# EUROPEAN PATENT SPECIFICATION

(11) **EP 3 605 228 B1**
(45) Date of publication and mention of the grant of the patent: **09.02.2022**
(21) Application number: 18775825.5
(22) Date of filing: 21.02.2018
(51) Int. Cl.: G03F 7/039, C08F 220/18, C08L 33/10, G03F 7/004, G03F 7/20

(54) **RADIATION SENSITIVE COMPOSITION AND RESIST PATTERN FORMING METHOD**
STRAHLUNGSEMPFINDLICHE ZUSAMMENSETZUNG UND VERFAHREN ZUR AUSBILDUNG VON RESISTSTRUKTUREN
COMPOSITION SENSIBLE AUX RAYONNEMENTS ET PROCÉDÉ DE FORMATION DE MOTIF DE RÉSERVE

(30) Priority: 30.03.2017 JP 2017068051
(43) Date of publication of application: 05.02.2020
(73) Proprietor: JSR Corporation, Minato-ku Tokyo 105-8640 (JP)
(72) Inventor: MARUYAMA Ken, Tokyo 105-8640 (JP)
(74) Representative: TBK
(86) International application number: PCT/JP2018/006324
(87) International publication number: WO 2018/180049

(56) References cited:
- WO-A1-2015/046021
- WO-A1-2016/158881
- JP-A- 2003 330 191
- JP-A- 2004 020 735
- JP-A- 2013 083 957
- JP-A- 2015 161 823
- JP-A- 2015 172 746
- US-A1- 2003 087 180
- US-A1- 2016 154 306

## Description

### [Technical Field]

The present invention relates to a radiation-sensitive composition and a resist pattern-forming method.

### [Background Art]

A radiation-sensitive composition for use in microfabrication by lithography generates an acid at a light-exposed region upon an exposure to an electromagnetic wave such as a far ultraviolet ray (ArF excimer laser beam, KrF excimer laser beam, etc.) or an extreme ultraviolet ray (EUV: Extreme Ultraviolet), a charged particle ray such as an electron beam. A chemical reaction in which the acid serves as a catalyst causes the difference in rates of dissolution in a developer solution, between light-exposed regions and light-unexposed regions to enable a resist pattern to be formed on a substrate.

Such radiation-sensitive compositions are demanded to have improved resist performances such as sensitivity and a LWR performance, along with miniaturization in processing techniques. To meet such demands, types, molecular structures and the like of polymers, acid generating agents and other components which may be used in the compositions have been investigated, and combinations thereof have been further investigated in detail (see, Japanese Unexamined Patent Application, Publication Nos. H11-125907, H8-146610 and 2000-298347).

### [Prior Art Documents]

### [Patent Documents]

Patent Document 1: Japanese Unexamined Patent Application, Publication No. H11-125907
Patent Document 2: Japanese Unexamined Patent Application, Publication No. H8-146610
Patent Document 3: Japanese Unexamined Patent Application, Publication No. 2000-298347

JP2013 083957 A, US2003/087180 A1, JP2015 172746 A and JP2015 161823 A disclose a radiation-sensitive composition comprising a polymer comprising a first structural unit that comprises an acid-labile group and a photoacid generator which dissociates the acid-labile group of the polymer under a condition of 110 °C and a time period of 1 minute. The radiation-sensitive composition comprises further an iodine atom as part of the polymer or an additional compound that comprises an iodine atom.

### [SUMMARY OF THE INVENTION]

### [Problems to be Solved by the Invention]

However, micro fabrication of resist patterns has proceeded to a level for line widths of no greater than 40 nm at present, whereby radiation-sensitive compositions are desired to have various resist performances being further improved, and in particular, to be capable of achieving high sensitivity also in cases of exposure to an electron beam, EUV and the like, as well as providing a further improved LWR performance. However, the conventional radiation-sensitive compositions have not satisfied these needs.

The present invention was made in view of the foregoing circumstances, and an object of the invention is to provide a radiation-sensitive composition that is superior in sensitivity and a LWR performance.

### [Means for Solving the Problems]

According to one aspect of the present invention made for solving the aforementioned problems, a radiation-sensitive composition comprises:
a polymer comprising a first structural unit that comprises an acid-labile group;
a first compound that generates a first acid upon an irradiation with a radioactive ray; and
a second compound that generates a second acid upon an irradiation with a radioactive ray,
wherein,
the first acid does not substantially dissociate the acid-labile group under a condition of a temperature of 110 °C and a time period of 1 min, and the second acid dissociates the acid-labile group under a condition of a temperature of 110 °C and a time period of 1 min, and
the radiation-sensitive composition satisfies at least one of requirements (1) and (2):
   (1) the polymer comprises a monovalent iodine atom; and
   (2) the radiation-sensitive composition further comprises a third compound that is other than the first compound or the second compound, and that comprises a monovalent iodine atom.

According to other aspect of the invention made for solving the aforementioned problems, a resist pattern-forming method comprising:
applying the radiation-sensitive composition of the one aspect of the invention directly or indirectly on a substrate;
exposing a film formed by the applying; and
developing the film exposed.

The term "acid-labile group" as referred to herein means a group that substitutes for a hydrogen atom included in a carboxy group, a hydroxy group or the like, the group serving to satisfy a relationship with the first compound and the second compound as described later. The term "compound" as referred to herein means a concept involving a polymer.

### [Effects of the Invention]

The radiation-sensitive composition and the resist pattern-forming method according to the aspects of the present invention enable a resist pattern with less LWR to be formed while achieving superior sensitivity. Therefore, these can be suitably used for working processes of semiconductor devices, and the like, in which microfabrication is expected to be further in progress hereafter.

### [Description of Embodiments]

### Radiation-Sensitive Composition

The radiation-sensitive composition contains: a polymer (hereinafter, may be also referred to as "polymer (A)") having a first structural unit (hereinafter, may be also referred to as "structural unit (I)") that includes an acid-labile group; a first compound (hereinafter, may be also referred to as "(B) photolabile base" or "photolabile base (B)") that generates a first acid (hereinafter, may be also referred to as "acid (1)") upon an irradiation with a radioactive ray; and a second compound (hereinafter, may be also referred to as "(C) acid generator" or "acid generator (C)") that generates a second acid (hereinafter, may be also referred to as "acid (2)") upon an irradiation with a radioactive ray, wherein, the acid (1) does not substantially dissociate the acid-labile group under a condition of a temperature of 110 °C and a time period of 1 min, and the acid (2) dissociates the acid-labile group under a condition of a temperature of 110 °C and a time period of 1 min, and the radiation-sensitive composition satisfies at least one of requirements (1) and (2).
(1) The polymer (A) includes a monovalent iodine atom.
(2) The radiation-sensitive composition further contains a third compound (hereinafter, may be also referred to as "(D) iodine-containing compound" or "iodine-containing compound (D)") that is other than the photolabile base (B) or the acid generator (C), and that includes a monovalent iodine atom.

It is to be noted that in a case in which the polymer (A) has a plurality of acid-labile groups, the first compound and the second compound are satisfactory as long as the relationship is satisfied with at least one acid-labile group, and it is preferred that the relationship is satisfied with the acid-labile group contained in a highest proportion (mol%), among the plurality of acid-labile groups included in the polymer (A).

It is possible to ascertain that the acid-labile group and the two types of compounds satisfy the aforementioned relationship in a subject composition containing: a polymer having an acid-labile group; and two types of compounds that generate an acid upon an irradiation with a radioactive ray, by the following test. First, a test composition is prepared containing a polymer having an acid-labile group, and one compound of the two types of compounds, similar to those used in the subject composition. Next, a film is formed by using this test composition, and the film is subjected to an ArF-exposure, whereby an acid is generated from the one compound and thereafter the film is heated at 110 °C for 1 min. According to this procedure, in a case in which no less than 5 mol% of acid-labile groups included in the polymer is dissociated, the acid generated from the one compound is determined to "dissociate the acid-labile group", whereas in a case in which only less than 5 mol% is dissociated, the acid generated from the one compound is determined to "not substantially dissociate the acid-labile group". This test is conducted also on other compound, and consequently the acid-labile group and the two types of compounds are determined as to satisfying of the relationship. However, in a case in which the acid generated from at least one compound of the two types of compounds has been known to dissociate or not substantially dissociate the acid-labile group, the test on the other compound may be omitted. It is to be noted that in the test composition, the contents of the polymer and the compound that generates acid are adjusted to be identical the contents in the subject composition. In addition, in a case in which the subject composition contains a solvent, the solvent should be used also in the test composition.

In a case in which the polymer (A) includes a monovalent iodine atom, it is preferred that the monovalent iodine atom bonds to an aromatic ring. Also, in a case in which the radiation-sensitive composition contains the iodine-containing compound (D), it is preferred that the monovalent iodine atom included in the iodine-containing compound (D) bonds to an aromatic ring. Due to the bonding of the monovalent iodine atom included in the polymer (A) and/or the iodine-containing compound (D) to the aromatic ring in this manner, the sensitivity of the radiation-sensitive composition can be more improved. It is to be noted that in a case in which the polymer (A) and/or the iodine-containing compound (D) include(s) a plurality of monovalent iodine atoms, a part of the monovalent iodine atom may bond to the aromatic ring, or the entirety of the monovalent iodine atom may bond to the aromatic ring.

The radiation-sensitive composition may further contain (E) a solvent and/or (F) an acid diffusion control agent, as well as other optional component(s), within a range not leading to impairment of the effects of the present invention.

Due to containing the polymer (A), the photolabile base (B) and the acid generator (C), and satisfying at least one of the condition (1) and condition (2), the radiation-sensitive composition is superior in the sensitivity and LWR performance. Although not necessarily clarified and without wishing to be bound by any theory, the reason for achieving the effects described above due to the radiation-sensitive composition having the aforementioned constitution is inferred as in the following, for example. The monovalent iodine atom included in the radiation-sensitive composition is considered to generate a large amount of electrons upon an exposure to EUV or the like. Therefore, the radiation-sensitive composition is believed to be superior in sensitivity due to promotion of a chemical reaction such as dissociation of the acid-labile group in the polymer (A), by a large amount of electrons generated upon the exposure to EUV or the like, and/or by a large amount of acid generated by a reaction of the electrons with the acid generator (C), etc. Moreover, even if a lower-molecular weight degradation product is produced through degradation of the polymer (A) that includes the monovalent iodine atom, and/or the iodine-containing compound (D) upon the exposure, the radiation-sensitive composition is believed to enable a negative influence from the degradation product to be reduced through an action of the photolabile base (B), leading to a superior LWR performance. Hereinafter, each component will be described.

### (A) Polymer

The polymer (A) has the structural unit (I) that includes an acid-labile group. The radiation-sensitive composition may contain either alone of one type, or in combination of two or more types of the polymer (A).

In a case in which the radiation-sensitive composition satisfies the condition (1), i.e., when the polymer (A) includes the monovalent iodine atom, it is preferred that the polymer (A) further has a second structural unit (hereinafter, may be also referred to as "structural unit (II)") that includes a monovalent iodine atom. In this case, the polymer (A) may include the monovalent iodine atom either in the structural unit (I), or at other site such as an end of the polymer.

In the case in which the polymer (A) includes the monovalent iodine atom, it is preferred that the monovalent iodine atom is not eliminated upon an irradiation with a radioactive ray. In the polymer (A), a monovalent iodine atom that is eliminated upon an irradiation with a radioactive ray may be, for example, the monovalent iodine atom included in the acid-labile group, or the like.

It is preferred that the polymer (A) further has a third structural unit (hereinafter, may be also referred to as "structural unit (III)") that is other than the structural units (I) to (II), and that includes a monovalent fluorine atom-containing group represented by - CR^{A}R^{B}OR^{C}, a lactone structure, a cyclic carbonate structure, a sultone structure, a hydroxy group bonding to an aromatic ring, or a combination thereof, wherein: R^{A} represents a fluorine atom or a fluorinated alkyl group; R^{B} represents a hydrogen atom, a fluorine atom or a monovalent organic group having 1 to 20 carbon atoms; and R^{C} represents a hydrogen atom or a monovalent organic group having 1 to 20 carbon atoms. The polymer (A) may further have other structural unit. In other words, the structural unit (III) does not include a monovalent iodine atom. The "organic group" as referred to herein means a group that includes at least one carbon atom. The polymer (A) may have one, or two or more types of each structural unit. Hereinafter, each structural unit will be described.

### Structural Unit (I)

The structural unit (I) is a structural unit that includes an acid-labile group. Examples of the structural unit (I) include a structural unit (I-1) represented by the following formula (2), and the like. In the following formula (2), the group represented by -CR¹⁵R¹⁶R¹⁷ is the acid-labile group.

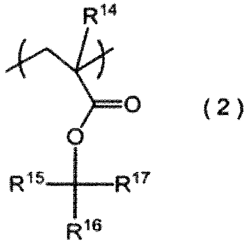

In the above formula (2), R¹⁴ represents a hydrogen atom, a fluorine atom, a methyl group or a trifluoromethyl group; R¹⁵ represents a monovalent hydrocarbon group having 1 to 20 carbon atoms; and R¹⁶ and R¹⁷ each independently represent a monovalent hydrocarbon group having 1 to 20 carbon atoms, or R¹⁶ and R¹⁷ taken together represent an alicyclic structure having 3 to 20 carbon atoms together with the carbon atom to which R¹⁶ and R¹⁷ bond.

The "hydrocarbon group" herein may include a chain hydrocarbon group, an alicyclic hydrocarbon group and an aromatic hydrocarbon group. This "hydrocarbon group" may be a saturated hydrocarbon group or an unsaturated hydrocarbon group. The "chain hydrocarbon group" as referred to herein means a hydrocarbon group not including a ring structure but comprising only a chain structure, and may involve both a straight chain hydrocarbon group and a branched hydrocarbon group. The "alicyclic hydrocarbon group" as referred to herein means a hydrocarbon group not including an aromatic ring structure but comprising only an alicyclic structure as the ring structure, and may involve both a monocyclic alicyclic hydrocarbon group and a polycyclic alicyclic hydrocarbon group. However, the alicyclic hydrocarbon group does not need to be constituted with only the alicyclic structure, and a part thereof may include a chain structure. The "aromatic hydrocarbon group" as referred to herein means a hydrocarbon group including an aromatic ring structure as the ring structure. However, the aromatic hydrocarbon group does not need to be constituted with only the aromatic ring structure, and a part thereof may include a chain structure and/or an alicyclic structure.

In light of a degree of copolymerization of a monomer that gives the structural unit (I), R¹⁴ represents preferably a hydrogen atom or a methyl group, and more preferably a methyl group.

The monovalent hydrocarbon group having 1 to 20 carbon atoms which may be represented by R¹⁵, R¹⁶ or R¹⁷ is exemplified by a monovalent chain hydrocarbon group having 1 to 20 carbon atoms, a monovalent alicyclic hydrocarbon group having 3 to 20 carbon atoms, a monovalent aromatic hydrocarbon group having 6 to 20 carbon atoms, and the like.

Examples of the monovalent chain hydrocarbon group having 1 to 20 carbon atoms include:
alkyl groups such as a methyl group, an ethyl group, a n-propyl group and an i-propyl group;
alkenyl groups such as an ethenyl group, a propenyl group and a butenyl group;
alkynyl groups such as an ethynyl group, a propynyl group and a butynyl group; and the like.

Examples of the monovalent alicyclic hydrocarbon group having 3 to 20 carbon atoms include:
monocyclic alicyclic saturated hydrocarbon groups such as a cyclopentyl group and a cyclohexyl group;
monocyclic alicyclic unsaturated hydrocarbon groups such as a cyclopentenyl group and a cyclohexenyl group;
polycyclic alicyclic saturated hydrocarbon groups such as a norbornyl group, an adamantyl group and a tricyclodecyl group;
polycyclic alicyclic unsaturated hydrocarbon groups such as a norbornenyl group and a tricyclodecenyl group; and the like.

Examples of the monovalent aromatic hydrocarbon group having 6 to 20 carbon atoms include:
aryl groups such as a phenyl group, a tolyl group, a xylyl group, a naphthyl group and an anthryl group;
aralkyl groups such as a benzyl group, a phenethyl group, a naphthylmethyl group and an anthryl methyl group; and the like.

Examples of the alicyclic structure having 3 to 20 carbon atoms which may be taken together represented by R¹⁶ and R¹⁷ together with the carbon atom to which R¹⁶ and R¹⁷ bond include a cyclopropane structure, a cyclobutane structure, a cyclopentane structure, a cyclohexane structure, a cyclopentene structure and a cyclohexene structure, a norbornane structure an adamantane structure, and the like.

The structural unit (1-1) is exemplified by structural units (hereinafter, may be also referred to as "structural units (I-1-1) to (1-1-5)") represented by the following formulae (2-1) to (2-5), and the like.

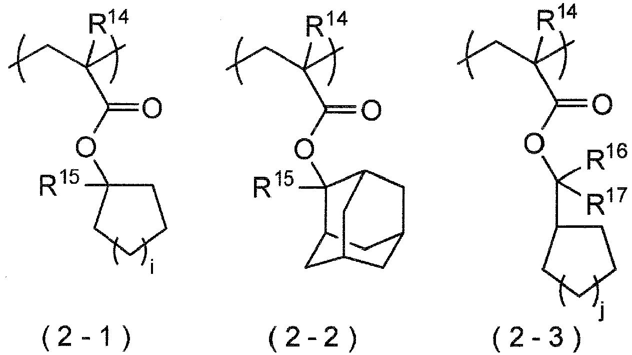

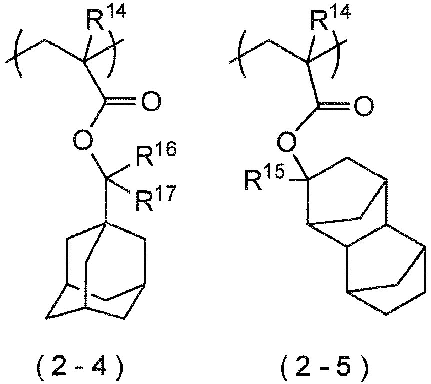

In the above formulae (2-1) to (2-5), R¹⁴ to R¹⁷ are as defined in the above formula (2); and i and j are each independently an integer of 1 to 4.

Examples of the structural units (I-1-1) to (1-1-5) include structural units represented by the following formulae, and the like.

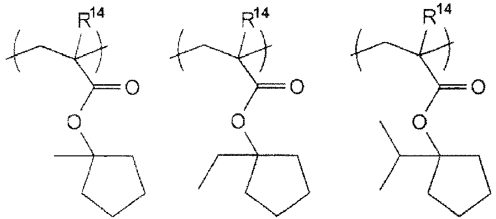

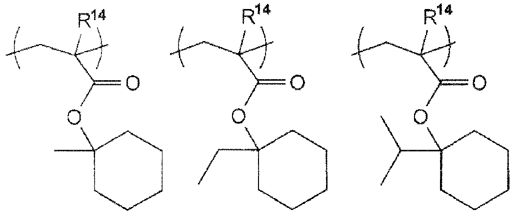

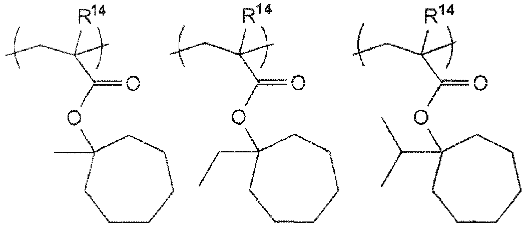

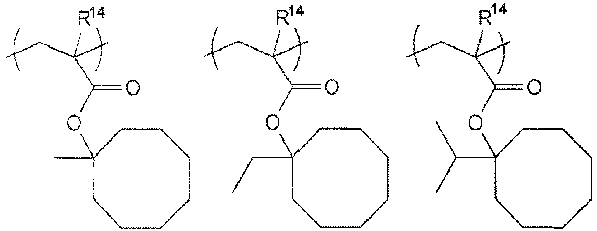

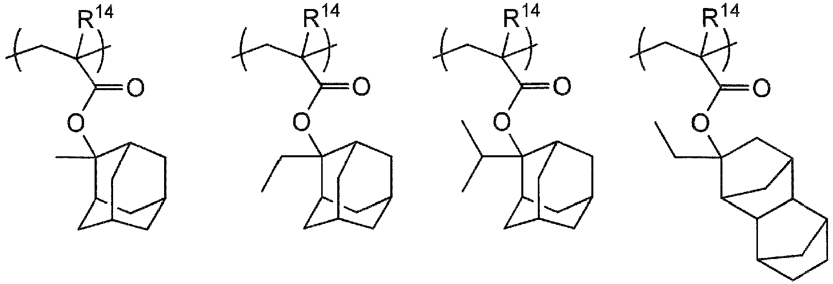

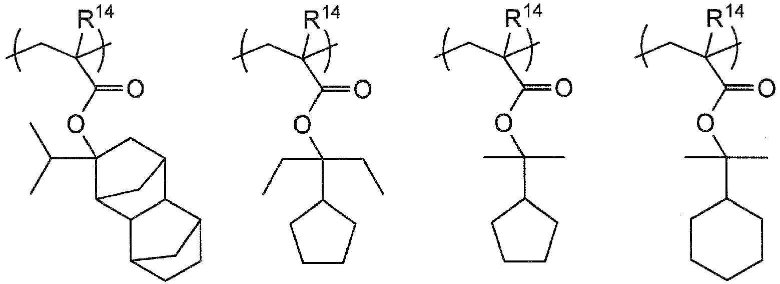

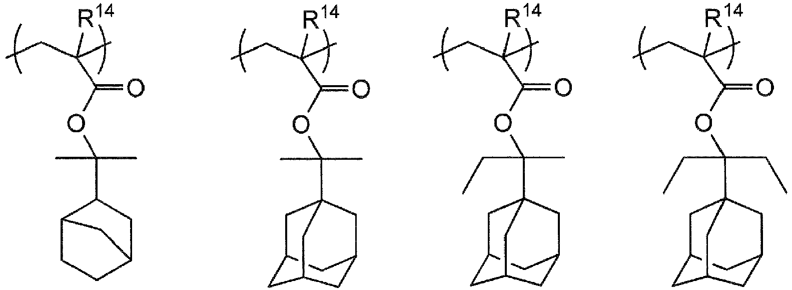

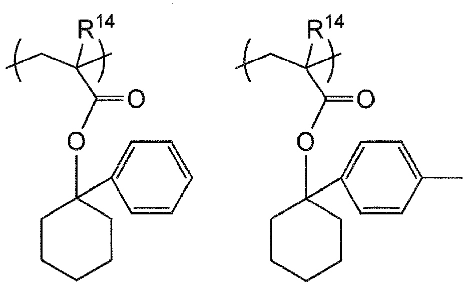

In the above formulae, R¹⁴ is as defined in the above formula (2).

The structural unit (I-1) is preferably one of the structural units (I-1-1) to (1-1-5), and more preferably a structural unit derived from 1-alkylcyclopentan-1-yl (meth)acrylate, a structural unit derived from 1-alkylcyclohexan-1-yl (meth)acrylate, a structural unit derived from 2-alkyladamantan-2-yl (meth)acrylate, a structural unit derived from 2-(adamantan-1-yl)propan-2-yl (meth)acrylate, a structural unit derived from 2-(cyclohexan-1-yl)propan-2-yl (meth)acrylate, or a structural unit derived from 2-alkyltetracyclododecan-2-yl (meth)acrylate.

The lower limit of the proportion of the structural unit (I) contained with respect to the total structural units constituting the polymer (A) is preferably 10 mol%, more preferably 20 mol%, and still more preferably 30 mol%. Meanwhile, the upper limit of the proportion is preferably 90 mol%, more preferably 70 mol%, and still more preferably 60 mol%. When the proportion of the structural unit (I) contained falls within the above range, the sensitivity and LWR performance of the radiation-sensitive composition can be more improved.

### Structural Unit (II)

The structural unit (II) is a structural unit that includes a monovalent iodine atom.

The number of the monovalent iodine atom included in the structural unit (II) is not particularly limited, and preferably no less than 1 and no greater than 10, more preferably no less than 1 and no greater than 5, and still more preferably no less than 1 and no greater than 3.

It is preferred that the structural unit (II) includes a monovalent group (X) represented by the following formula (X).

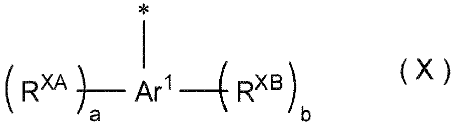

In the above formula (X), Ar¹ represents a group obtained by removing (a + b) hydrogen atoms from an unsubstituted aryl group having 6 to 20 carbon atoms; R^{XA} represents a monovalent iodine atom, an iodinated alkyl group having 1 to 20 carbon atoms or an iodinated alkoxy group having 1 to 20 carbon atoms; R^{XB} represents a hydroxy group, -NH₂, a fluorine atom, a chlorine atom or a monovalent organic group having 1 to 20 carbon atoms; a is an integer of 1 to 10; b is an integer of 0 to 10, wherein in a case in which a is no less than 2, a plurality of R^{XA}s may be identical or different, and in a case in which b is no less than 2, a plurality of R^{XB}s may be identical or different; and ^{∗} denotes a bonding site to a part other than the group (X) in the structural unit (II).

Examples of the unsubstituted aryl group in connection with Ar¹ include a phenyl group, a naphthyl group, an anthracenyl group, an indenyl group, an indanyl group, an acenaphthylenyl group, a fluorenyl group, a phenanthrenyl group, and the like. Of these, a phenyl group and a naphthyl group are preferred.

The upper limit of the number of carbon atoms of the iodinated alkyl group and iodinated alkoxy group which may be represented by R^{XA}, and the monovalent organic group which may be represented by R^{XB} is preferably 10, more preferably 5, and still more preferably 3.

The number of monovalent iodine atom in the iodinated alkyl group and the iodinated alkoxy group which may be represented by R^{XA} is preferably no less than 1 and no greater than 3, and more preferably 1.

The monovalent organic group which may be represented by R^{XB} is exemplified by: a monovalent hydrocarbon group having 1 to 20 carbon atoms, a monovalent group (α) that includes a divalent hetero atom-containing group between two adjacent carbon atoms of the monovalent hydrocarbon group; a monovalent group (β) obtained by substituting a part or all of hydrogen atoms included in the monovalent hydrocarbon group or the group (α) with a monovalent hetero atom-containing group; a monovalent group (γ) obtained by combining at least one of the monovalent hydrocarbon group, the group (α) and the group (β) with a divalent hetero atom-containing group; and the like.

Examples of the monovalent hydrocarbon group having 1 to 20 carbon atoms include groups similar to those exemplified for the monovalent hydrocarbon group which may be represented by R¹⁵, R¹⁶ or R¹⁷ in the above formula (2), and the like.

Examples of the divalent hetero atom-containing group include -O-, -S-, -NR'-, - CO-, -COO-, -CS-, and the like. R' represents a hydrogen atom or a monovalent hydrocarbon group having 1 to 10 carbon atoms. Examples of the monovalent hetero atom-containing group include -OH, -SH, -CN, -NHR', -COR', -CSR', and the like.

Specific examples of the monovalent organic group which may be represented by R^{XB} include an alkyl group, an alkoxy group, an acyl group, an alkoxycarbonyl group and the like, and of these, a methyl group, a methoxy group, an acetyl group and a methoxycarbonyl group are preferred.

The upper limit of a and b is preferably 5, and more preferably 3. Furthermore, the upper limit of the sum of a and b is preferably 10, and more preferably 5.

The structural unit (II) that includes the monovalent group (X) is exemplified by a structural unit (II-1) represented by the following formula (X-1), and the like.

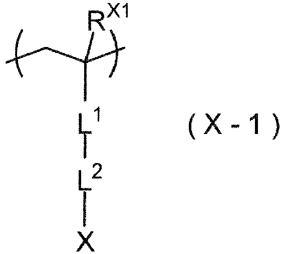

In the above formula (X-1), R^{X1} represents a hydrogen atom, a methyl group, a fluorine atom or a trifluoromethyl group; L¹ represents a single bond, -O-, -CO-, -COO-, - CONR"-, -SO₂-, -SO₂O- or -SO₂NR"-, wherein R" represents a hydrogen atom or a monovalent hydrocarbon group having 1 to 10 carbon atoms L² represents a divalent organic group having 1 to 20 carbon atoms; and X represents a monovalent group represented by the above formula (X).

In light of a degree of copolymerization of a monomer that gives the structural unit (II-1), R^{X1} represents preferably a hydrogen atom or a methyl group, and more preferably a methyl group.

L¹ represents preferably -COO- or -CONH-.

The upper limit of the number of carbon atoms of the divalent organic group represented by L² is preferably 10, and more preferably 5.

Examples of the divalent organic group represented by L² include groups obtained by removing one hydrogen atom from those exemplified for the monovalent organic group which may be represented by R^{XB} in the above formula (X), and the like.

Specific examples of the divalent organic group represented by L² include substituted or unsubstituted alkanediyl groups, substituted or unsubstituted cycloalkanediyl groups, substituted or unsubstituted arylene groups, divalent groups obtained by combining at least one of these groups with at least one of -O-, -CO- and -S-, and the like. Examples of the substituent in the alkanediyl group, the cycloalkanediyl group and the arylene group include a fluorine atom, an alkoxy group, and the like.

L² represents preferably a single bond.

Examples of the structural unit (II) include structural units represented by the following formulae, and the like.

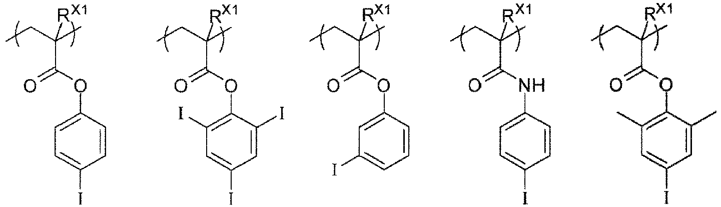

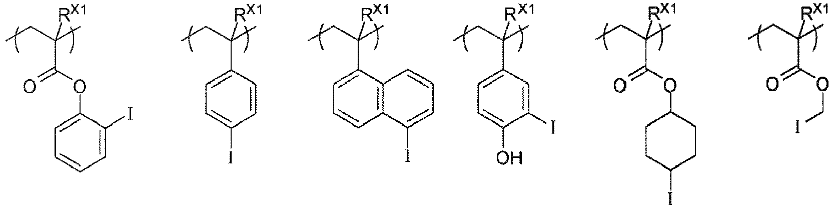

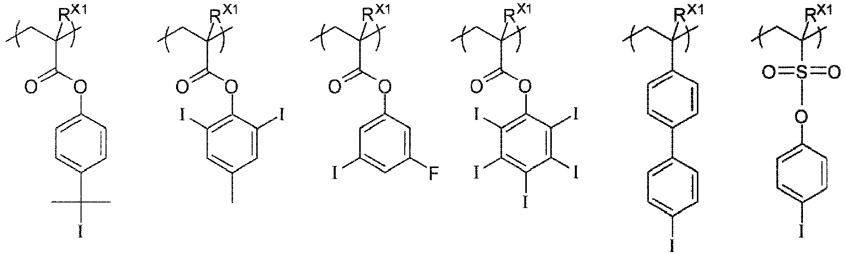

In a case in which the polymer (A) has the structural unit (II), the lower limit of the proportion of the structural unit (II) contained with respect to the total structural units constituting the polymer (A) is preferably 1 mol%, more preferably 5 mol%, and still more preferably 15 mol%. Meanwhile, the upper limit of the proportion of the structural unit (II) contained is preferably 60 mol%, more preferably 40 mol%, and still more preferably 30 mol%. When the proportion of the structural unit (II) contained falls within the above range, the sensitivity and LWR performance of the radiation-sensitive composition can be more improved.

### Structural Unit (III)

The structural unit (III) is a structural unit other than the structural units (I) to (II), and includes a monovalent fluorine atom-containing group represented by -CR^{A}R^{B}OR^{C}, a lactone structure, a cyclic carbonate structure, a sultone structure, a hydroxy group bonding to an aromatic ring, or a combination thereof, wherein: R^{A} represents a fluorine atom or a fluorinated alkyl group; R^{B} represents a hydrogen atom, a fluorine atom or a monovalent organic group having 1 to 20 carbon atoms; and R^{C} represents a hydrogen atom or a monovalent organic group having 1 to 20 carbon atoms. In other words, the structural unit (III) does not include a monovalent iodine atom. When the polymer (A) further has the structural unit (III), the solubility in a developer solution can be appropriately adjusted, and as a result, the sensitivity and LWR performance of the radiation-sensitive composition can be more improved. In addition, adhesiveness between the substrate and the film formed from the radiation-sensitive composition can be improved. Moreover, in a case in which the polymer (A) has the structural unit (III) that includes a hydroxy group bonding to an aromatic ring, the sensitivity of the radiation-sensitive composition can be particularly effectively improved.

The lactone structure as referred to herein means a structure having one ring (lactone ring) that includes a group represented by -O-C(O)-. The cyclic carbonate structure as referred to herein means a structure having one ring (cyclic carbonate ring) that includes a group represented by -O-C(O)-O-. The sultone structure as referred to herein means a structure having one ring (sultone ring) that includes a group represented by -O-S(O)₂-.

Examples of the hydroxy group bonding to an aromatic ring include a hydroxy group bonding to a benzene ring, a hydroxy group bonding to a naphthalene ring, and the like.

The number of carbon atoms of the fluorinated alkyl group which may be represented by R^{A}, and the monovalent organic group which may be represented by R^{B} or R^{C} is preferably 1 to 10, and more preferably 1 to 3.

R^{A} represents preferably a fluorine atom or a perfluoroalkyl group, and more preferably a fluorine atom or a trifluoromethyl group.

Examples of the monovalent organic group which may be represented by R^{B} or R^{C} include groups similar to those exemplified for the monovalent organic group which may be represented by R^{XB} in the above formula (X), and the like.

R^{B} represents preferably a monovalent organic group that includes a fluorine atom, or a fluorine atom, more preferably a fluorinated alkyl group or a fluorine atom, still more preferably a perfluoroalkyl group or a fluorine atom, and particularly preferably a trifluoromethyl group or a fluorine atom.

R^{C} represents preferably a hydrogen atom or an alkyl group, and more preferably a hydrogen atom or a methyl group.

The structural unit (III) that includes the monovalent fluorine atom-containing group is exemplified by structural units represented by the following formulae, and the like.

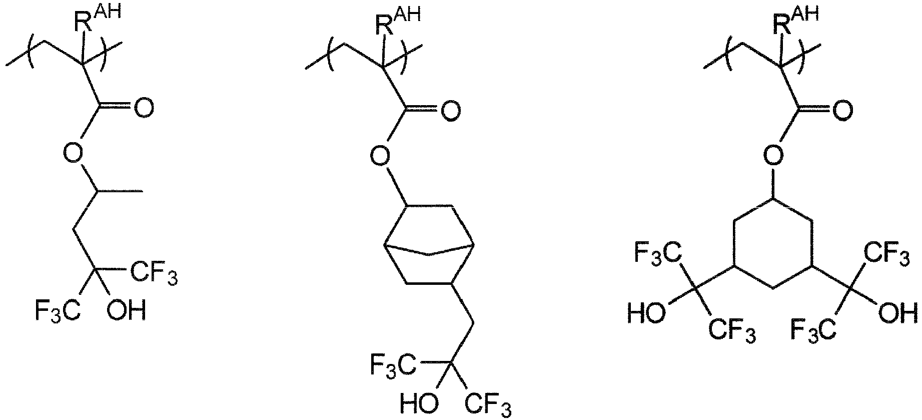

In the above formulae, R^{AH} represents a hydrogen atom, a fluorine atom, a methyl group or a trifluoromethyl group.

The structural unit (III) that includes a hydroxy group bonding to an aromatic ring is exemplified by structural units represented by the following formulae (f-1) to (f-6), and the like.

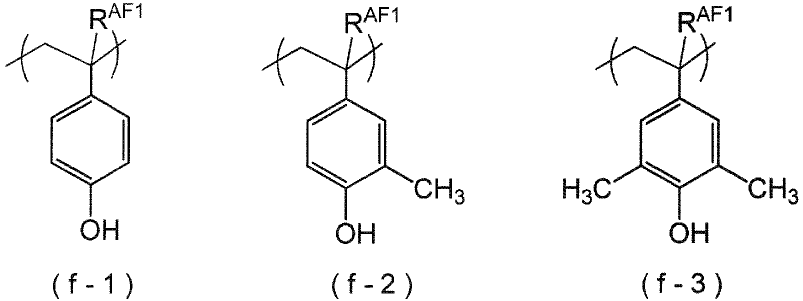

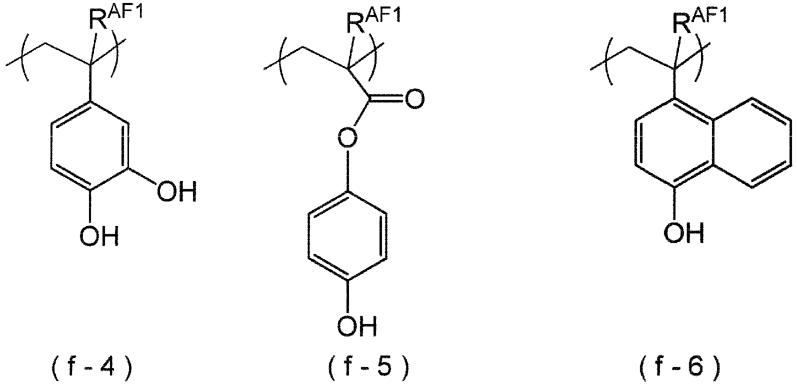

In the above formulae (f-1) to (f-6), R^{AF1} represents a hydrogen atom or a methyl group.

As the structural unit (III) that includes a hydroxy group bonding to an aromatic ring, the structural unit represented by the above formula (f-1), and the structural unit represented by the above formula (f-5) are preferred.

The structural unit (III) that includes a hydroxy group bonding to an aromatic ring may be formed by, for example: a process of polymerizing by using a monomer that includes a hydroxy group bonding to an aromatic ring; a process of hydrolyzing a polymer obtained by using acyloxystyrene such as acetoxystyrene, or the like in the presence of a base such as triethylamine; or the like.

The structural unit (III) (hereinafter, may be also referred to as "structural unit (III-1)") that includes a lactone structure, a cyclic carbonate structure, a sultone structure or a combination thereof is exemplified by structural units represented by the following formulae, and the like.

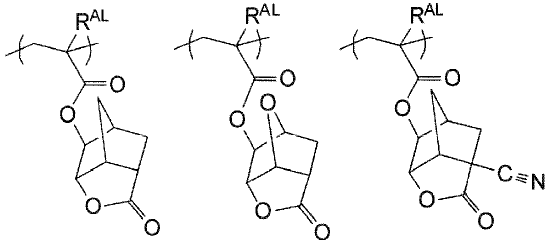

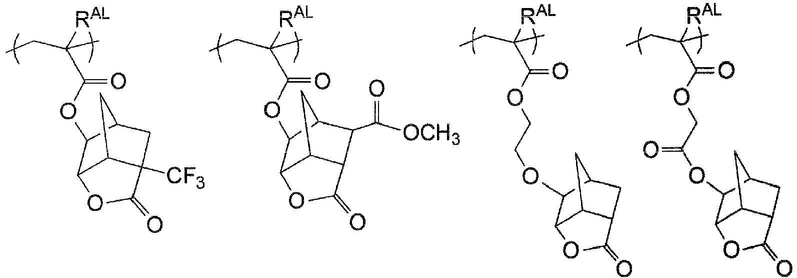

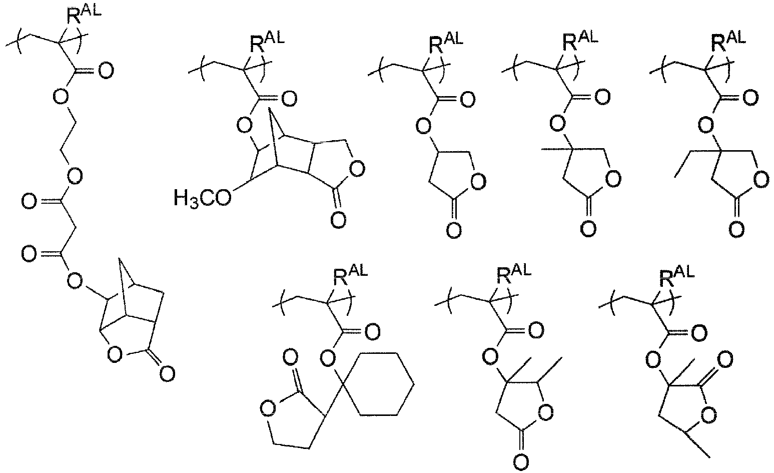

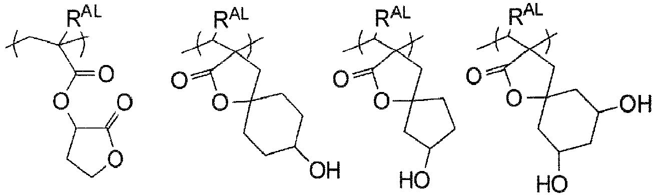

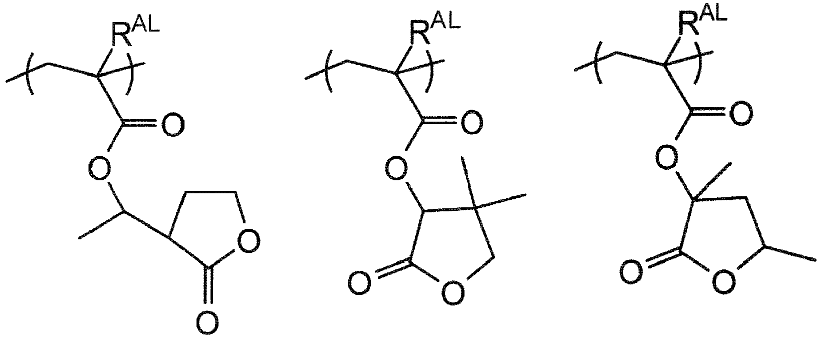

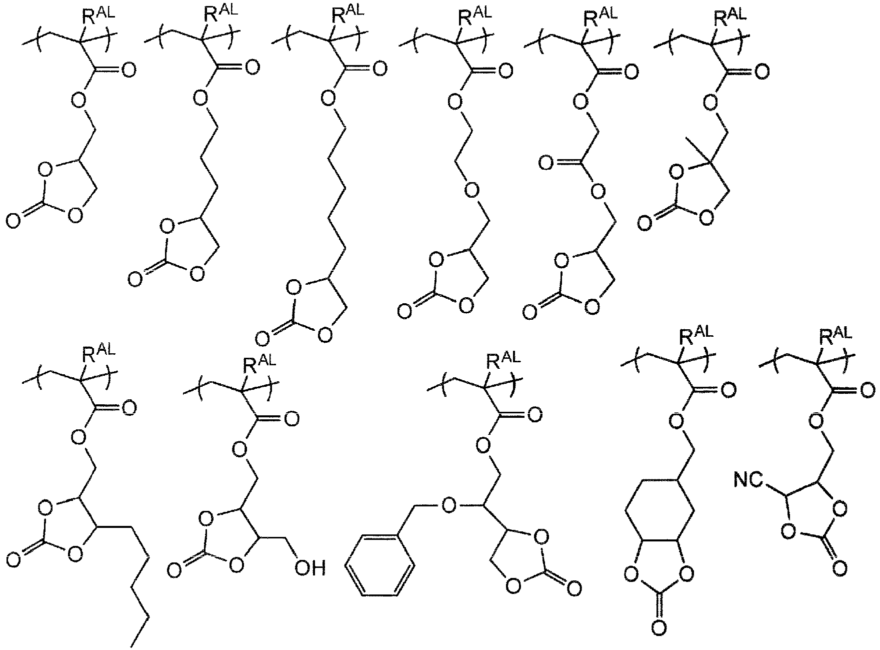

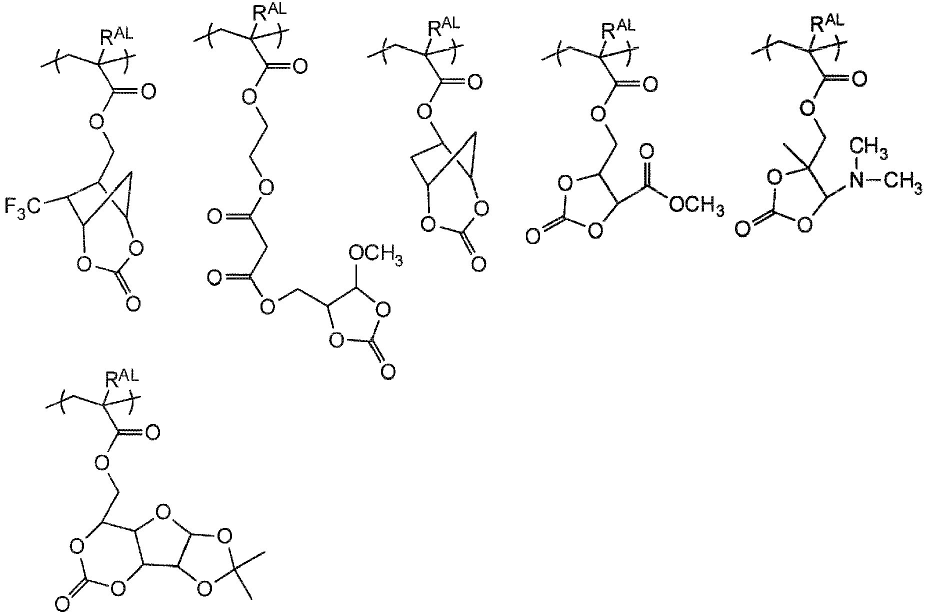

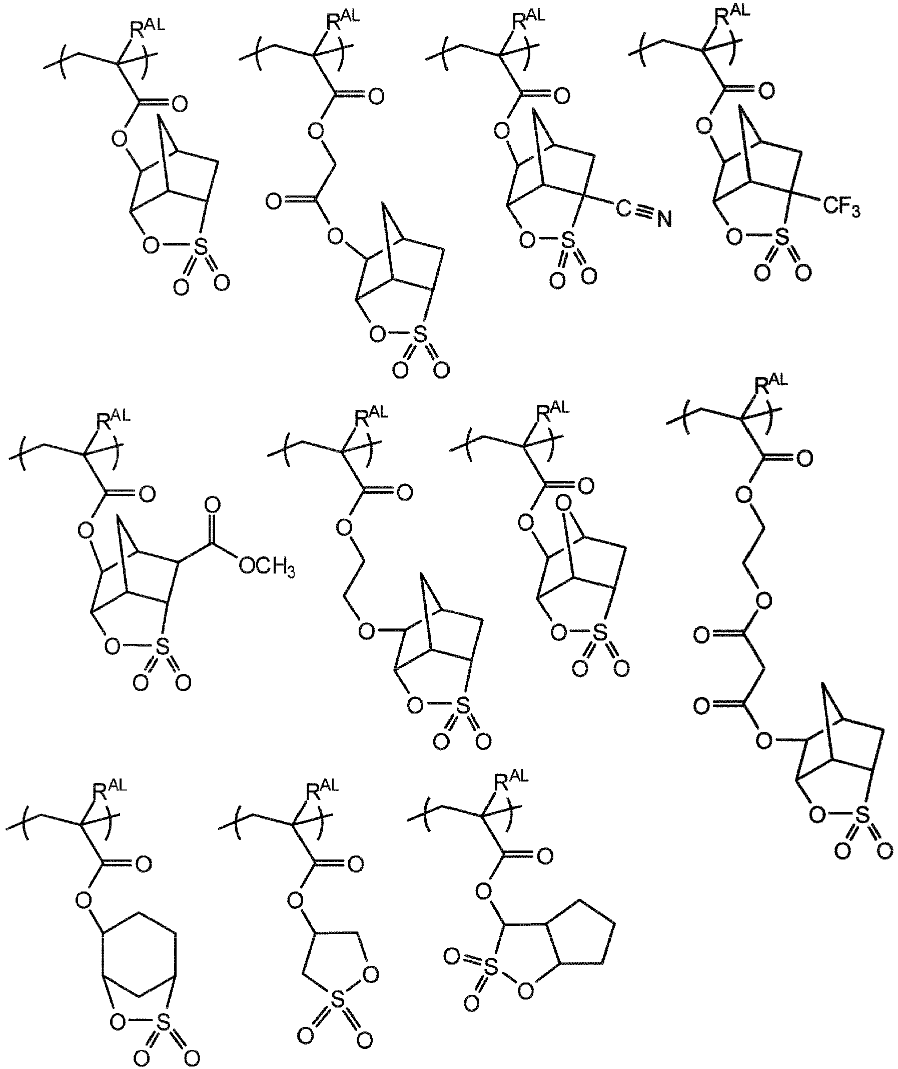

In the above formulae, R^{AL} represents a hydrogen atom, a fluorine atom, a methyl group, or a trifluoromethyl group.

In light of a degree of copolymerization of a monomer that gives the structural unit (III-1), R^{AL} represents preferably a hydrogen atom or a methyl group, and more preferably a methyl group.

As the structural unit (III-1), a structural unit that includes a norbornanelactone structure, a structural unit that includes an oxanorbornanelactone structure, a structural unit that includes a γ-butyrolactone structure, a structural unit that includes an ethylene carbonate structure, and a structural unit that includes a norbornanesultone structure are preferred.

In a case in which the polymer (A) has the structural unit (III), the lower limit of the proportion of the structural unit (III) contained with respect to the total structural units constituting the polymer (A) is preferably 5 mol%, more preferably 15 mol%, and still more preferably 30 mol%. Meanwhile, the upper limit of the proportion of the structural unit (III) contained is preferably 90 mol%, more preferably 70 mol%, and still more preferably 60 mol%. When the proportion of the structural unit (III) contained falls within the above range, the sensitivity and LWR performance of the radiation-sensitive composition can be more improved.

### Other Structural Unit

The polymer (A) may further have other structural unit than the structural units (I) to (III). The other structural unit is exemplified by a structural unit that includes a polar group, a structural unit that includes a nondissociable hydrocarbon group, and the like. Examples of the polar group include an alcoholic hydroxy group, a carboxy group, a cyano group, a nitro group, a sulfonamide group, and the like. Examples of the nondissociable hydrocarbon group include linear alkyl groups, and the like. When the polymer (A) has the other structural unit, solubility of the polymer (A) in a developer solution can be more appropriately regulated.

The upper limit of the proportion of the other structural unit contained with respect to the total structural units constituting the polymer (A) is preferably 50 mol%, more preferably 30 mol%, and still more preferably 20 mol%. When the proportion of the other structural unit contained falls within the above range, the solubility of the polymer (A) in a developer solution can be more appropriately regulated.

### Synthesis Procedure of Polymer (A)

The polymer (A) may be synthesized by, for example, polymerizing a monomer that gives each structural unit in the presence of a radical polymerization initiator, etc., in an appropriate solvent. In the polymerization, a chain transfer agent such as t-dodecyl mercaptan may be further used.

The radical polymerization initiator is exemplified by an azo radical initiator, a peroxide radical initiator, and the like. Specific examples of the radical polymerization initiator include compounds disclosed in paragraph [0121] of Japanese Unexamined Patent Application, Publication No. 2016-173513, and the like. Of these, azobisisobutyronitrile (AIBN) and dimethyl 2,2'-azobisisobutyrate are preferred, and AIBN is more preferred as the radical polymerization agent. These radical initiators may be used either alone of one type, or in combination of two or more types thereof.

The solvent for use in the polymerization is exemplified by alkanes, cycloalkanes, aromatic hydrocarbons, halogenated hydrocarbons, saturated carboxylic acid esters, ketones, ethers, alcohols, and the like. Specific examples of the solvent include solvents disclosed in paragraph [0122] of Japanese Unexamined Patent Application, Publication No. 2016-173513, as well as propylene glycol monomethyl ether, and the like. These solvents may be used either alone of one type, or in combination of two or more types thereof.

The lower limit of the reaction temperature in the polymerization is preferably 40 °C, and more preferably 50 °C. Meanwhile, the upper limit of the reaction temperature is preferably 150 °C, and more preferably 120 °C. The lower limit of the reaction time period in the polymerization is preferably 1 hour, and more preferably 2 hrs. Meanwhile, the upper limit of the reaction time period is preferably 48 hrs, and more preferably 24 hrs.

The lower limit of the weight average molecular weight (Mw) of the polymer (A) is preferably 1,000, more preferably 3,000, and still more preferably 5,000. Meanwhile, the upper limit of Mw is preferably 50,000, more preferably 20,000, and still more preferably 8,000. When Mw of the polymer (A) falls within the above range, coating characteristics of the radiation-sensitive composition can be improved.

The lower limit of the ratio (Mw/Mn) of Mw to the number average molecular weight (Mn) of the polymer (A) is typically 1, and preferably 1.3. Meanwhile, the upper limit of Mw/Mn is preferably 5, more preferably 3, still more preferably 2, and particularly preferably 1.8. When the Mw/Mn falls within the above range, the sensitivity and LWR performance of the radiation-sensitive composition can be more improved.

As referred to herein, Mw and Mn of each polymer are values determined by using gel permeation chromatography (GPC) under the following conditions:
GPC columns: for example, "G2000 HXL" x 2, "G3000 HXL" x 1, and "G4000 HXL" x 1, manufactured by Tosoh Corporation;
column temperature: 40 °C;
elution solvent: tetrahydrofuran;
flow rate: 1.0 mL/min;
sample concentration: 1.0% by mass;
amount of injected sample: 100 µL;
detector: differential refractometer; and
standard substance: mono-dispersed polystyrene

The lower limit of the content of the polymer (A) with respect to the total polymer contained in the radiation-sensitive composition is preferably 60% by mass, more preferably 70% by mass, and still more preferably 90% by mass. Meanwhile, the upper limit of the content is not particularly limited, and is, for example, 99% by mass. When the content of the polymer (A) falls within the above range, the sensitivity and LWR performance of the radiation-sensitive composition can be more improved.

The lower limit of the content of the polymer (A) in the radiation-sensitive composition in terms of the solid content equivalent is preferably 50% by mass, more preferably 70% by mass, and still more preferably 80% by mass. Meanwhile, the upper limit of the content of is preferably 99% by mass, still more preferably 95% by mass, and still more preferably 90% by mass. When the content falls within the above range, the sensitivity and LWR performance of the radiation-sensitive composition can be more improved. The "solid content" as referred to herein means components in the radiation-sensitive composition, other than the solvent (E) and a localization accelerator described later.

### (B) Photolabile Base

The photolabile base (B) is a compound that generates an acid (1) upon an irradiation with a radioactive ray, and the acid (1) does not substantially dissociate the acid-labile group of the polymer (A) under a condition of a temperature of 110 °C and a time period of 1 min. In the radiation-sensitive composition, the photolabile base (B) may be used either alone of one type, or in combination of two or more types thereof. The photolabile base (B) is in general, a compound that generates upon an exposure, the acid (1) which does not cause or is less likely to cause a dissociation reaction of the acid-labile group, under the condition employed.

The compound that can be used as the photolabile base (B) may be appropriately selected in accordance with dissociability of the acid-labile group included in the polymer (A), and a case in which the polymer (A) has the structural unit (I-1), i.e., a case in which the polymer (A) has the acid-labile group represented by -CR¹⁵R¹⁶R¹⁷ in the above formula (2) is specifically described as an example in the following.

The photolabile base (B) is exemplified by an onium salt compound that is decomposed upon the exposure to lose acid diffusion controllability, and the like. Examples of the onium salt compound include a compound represented by the following formula (B), and the like.

B⁻ S⁺ (B)

In the above formula (B), B⁻ represents OH⁻, R^{α}-COO⁻, R^{α}-OCO-COO⁻, R^{α}-N⁻-SO₂-R^{β}, R^{β}-COO⁻, an anion represented by the following formula (5-3) or an anion represented by the following formula (5-4); R^{α}s each independently represent an alkyl group, a monovalent alicyclic saturated hydrocarbon group, an aryl group or an aralkyl group; R^{β} represents a fluorinated alkyl group; and S⁺ represents a radiation-sensitive monovalent onium cation.

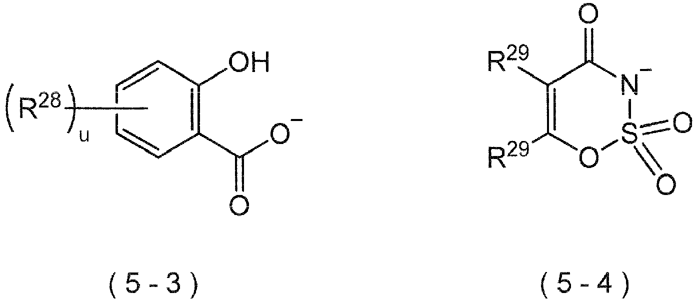

In the above formula (5-3), R²⁸ represents a linear or branched alkyl group having 1 to 12 carbon atoms, a linear or branched fluorinated alkyl group having 1 to 12 carbon atoms or a linear or branched alkoxy group having 1 to 12 carbon atoms; and u is an integer of 0 to 2, wherein in a case in which u is 2, two R²⁸s may be identical or different.

In the above formula (5-4), R²⁹s each independently represent a hydrogen atom, an alkyl group having 1 to 12 carbon atoms, a monovalent alicyclic saturated hydrocarbon group having 1 to 12 carbon atoms, an aryl group or an aralkyl group.

The upper limit of the number of carbon atoms of the alkyl group, the monovalent alicyclic saturated hydrocarbon group, the aryl group and the aralkyl group which may be represented by R^{α} is preferably 20, more preferably 15, and still more preferably 12. Meanwhile, the lower limit of the number of carbon atoms is preferably 3, more preferably 5, and still more preferably 8.

R^{α} represents preferably the monovalent alicyclic saturated hydrocarbon group, more preferably the monovalent polycyclic alicyclic saturated hydrocarbon group, and still more preferably an adamantyl group.

The upper limit of the number of carbon atoms of the fluorinated alkyl group represented by R^{β} is preferably 20, more preferably 10, and still more preferably 5. The lower limit of the number of carbon atoms is typically 1, and preferably 3.

As the fluorinated alkyl group represented by R^{β}, a perfluoroalkyl group is preferred.

It is preferred that u is 0.

The anion represented by B⁻ is preferably R^{α}-N⁻-SO₂-R^{β}, R^{α}-OCO-COO⁻, the anion represented by the above formula (5-3) or the anion represented by the above formula (5-4).

The radiation-sensitive monovalent onium cation represented by S⁺ is exemplified by a cation (hereinafter, may be also referred to as "cation (r-a)") represented by the following formula (r-a), a cation (hereinafter, may be also referred to as "cation (r-b)") represented by the following formula (r-b), a cation (hereinafter, may be also referred to as "cation (r-c)") represented by the following formula (r-c), and the like.

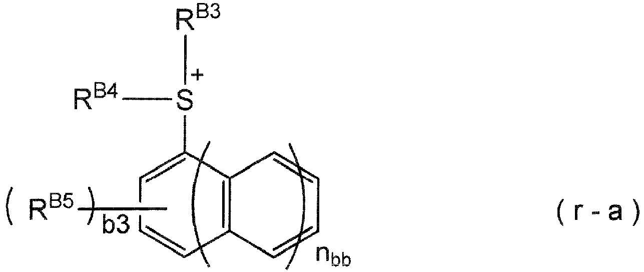

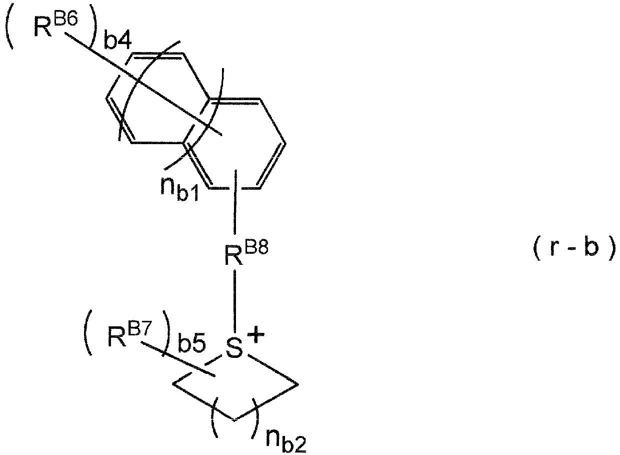

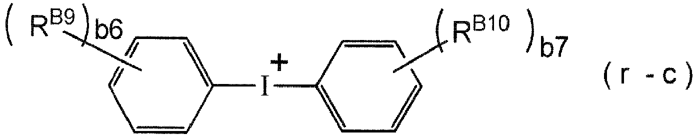

In the above formula (r-a), R^{B3} and R^{B4} each independently represent a monovalent organic group having 1 to 20 carbon atoms; R^{B5} represents a monovalent organic group having 1 to 20 carbon atoms, a hydroxy group, a nitro group or a halogen atom; b3s are each independently an integer of 0 to 5, wherein in a case in which there exists a plurality of R^{B5}s, the plurality of R^{B5}s may be identical or different, or the plurality of R^{B5}s may taken together represent a ring structure; and n_{bb} is an integer of 0 to 3.

Examples of the monovalent organic group having 1 to 20 carbon atoms which may be represented by R^{B3}, R^{B4} or R^{B5} include groups similar to those exemplified for the monovalent organic group which may be represented by R^{XB} in the above formula (X), and the like.

As R^{B3} and R^{B4}, a substituted or unsubstituted monovalent hydrocarbon group having 1 to 20 carbon atoms is preferred, a substituted or unsubstituted monovalent aromatic hydrocarbon group having 6 to 18 carbon atoms is more preferred, and a phenyl group is still more preferred.

As a substituent in the monovalent hydrocarbon group having 1 to 20 carbon atoms represented by R^{B3} or R^{B4}, a substituted or unsubstituted monovalent hydrocarbon group having 1 to 20 carbon atoms, -OSO₂-R^{k}, -SO₂-R^{k}, -OR^{k}, -COOR^{k}, -O-CO-R^{k}, -OR^{kk}-COOR^{k}, -R^{kk}-CO-R^{k} and -S-R^{k} are preferred. R^{k} represents a monovalent hydrocarbon group having 1 to 10 carbon atoms; and R^{kk} represents a single bond or a divalent hydrocarbon group having 1 to 10 carbon atoms. It is to be noted that the definitions of R^{k} and R^{kk} are similar to R^{B6}, R^{B7}, R^{B9}, R^{B10} and the like described below.

As R^{B5}, a substituted or unsubstituted monovalent hydrocarbon group having 1 to 20 carbon atoms, -OSO₂-R^{k}, -SO₂-R^{k}, -OR^{k}, -COOR^{k}, -O-CO-R^{k}, -O-R^{kk}-COOR^{k}, -R^{kk}-CO-R^{k} and -S-R^{k} are preferred.

In the above formula (r-b), R^{B6} and R^{B7} each independently represent a monovalent organic group having 1 to 20 carbon atoms, a hydroxy group, a nitro group or a halogen atom; b4 is an integer of 0 to 7, wherein in a case in which there exists a plurality of R^{B6}s, the plurality of R^{B6}s may be identical or different, or the plurality of R^{B6}s may taken together represent a ring structure; b5 is an integer of 0 to 6, wherein in a case in which there exists a plurality of R^{B7}s, the plurality of R^{B7}s may be identical or different, or the plurality of R^{B7}s may taken together represent a ring structure; n_{b1} is an integer of 0 to 2; n_{b2} is an integer of 0 to 3; and R^{B8} represents a single bond or a divalent organic group having 1 to 20 carbon atoms.

As R^{B6} and R^{B7}, a substituted or unsubstituted monovalent hydrocarbon group having 1 to 20 carbon atoms, -OR^{k}, -COOR^{k}, -O-CO-R^{k}, -O-R^{kk}-COOR^{k} and -R^{kk}-CO-R^{k} are preferred.

In the above formula (r-c), R^{B9} and R^{B10} each independently represent a monovalent organic group having 1 to 20 carbon atoms, a hydroxy group, a nitro group or a halogen atom; b6 and b7 are each independently an integer of 0 to 5; in a case in which there exists a plurality of R^{B9}s, the plurality of R^{B9}s may be identical or different, or the plurality of R^{B9}s may taken together represent a ring structure, wherein in a case in which there exists a plurality of R^{B10}s, the plurality of R^{B10}s may be identical or different, or the plurality of R^{B10}s may taken together represent a ring structure.

As R^{B9} and R^{B10}, a substituted or unsubstituted monovalent hydrocarbon group having 1 to 20 carbon atoms, -OSO₂-R^{k}, -SO₂-R^{k}, -OR^{k}, -COOR^{K}, -O-R^{k}-, -O-CO-R^{k}, -OR^{kk}-COOR^{k}, -R^{kk}-CO-R^{k}, -S-R^{k}, and the ring structure represented by at least two of these groups taken together are preferred.

The monovalent hydrocarbon group having 1 to 20 carbon atoms which may be represented by R^{B5}, R^{B6}, R^{B7}, R^{B9} or R^{B10} include:
linear alkyl groups such as a methyl group, an ethyl group, a n-propyl group and a n-butyl group,
branched alkyl groups such as an i-propyl group, an i-butyl group, a sec-butyl group and a t-butyl group;
aryl groups such as a phenyl group, a tolyl group, a xylyl group, a mesityl group and a naphthyl group;
aralkyl groups such as a benzyl group and a phenethyl group, and the like.

Examples of the divalent organic group which may be represented by R^{B8} include groups obtained by removing one hydrogen atom from those exemplified for the monovalent organic group which may be represented by R^{XB} in the above formula (X), and the like.

Examples of a substituent in the hydrocarbon group which may be represented by R^{B5}, R^{B6}, R^{B7}, R^{B9} or R^{B10} include halogen atoms such as a fluorine atom, a chlorine atom, a bromine atom and an iodine atom, a hydroxy group, a carboxy group, a cyano group, a nitro group, an alkoxy group, an alkoxycarbonyl group, an alkoxycarbonyloxy group, an acyl group, an acyloxy group, and the like. Of these, the halogen atom is preferred, and a fluorine atom is more preferred.

As R^{B5}, R^{B6}, R^{B7}, R^{B9} and R^{B10}, a linear or branched alkyl group, a monovalent fluorinated alkyl group, a monovalent aromatic hydrocarbon group, -OSO₂-R^{k} and -SO₂-R^{k} are preferred, and the monovalent fluorinated alkyl group and the monovalent aromatic hydrocarbon group are more preferred, and the monovalent fluorinated alkyl group is still more preferred.

In the above formula (r-a): b3 is preferably an integer of 0 to 2, more preferably 0 or 1, and still more preferably 0; and n_{bb} is preferably 0 or 1, and more preferably 0. In the above formula (r-b): b4 is preferably an integer of 0 to 2, more preferably 0 or 1, and still more preferably 0; b5 is preferably an integer of 0 to 2, more preferably 0 or 1, and still more preferably 0; n_{b1} is preferably 0 or 1, and more preferably 0; and n_{b2} is preferably 2 or 3, and more preferably 2. In the above formula (r-c), b6 and b7 are each preferably an integer of 0 to 2, more preferably 0 or 1, and still more preferably 0.

Of these, the radiation-sensitive monovalent onium cation represented by S⁺ is preferably the cation (r-a), and more preferably a triphenylsulfonium cation.

The photolabile base (B) is exemplified by compounds represented by the following formulae (b-1) to (b-5), and the like.

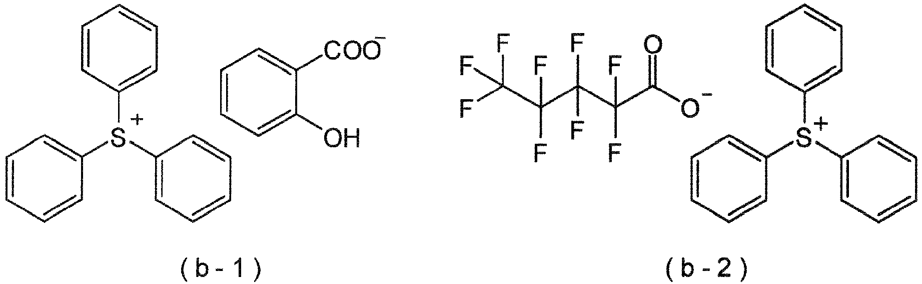

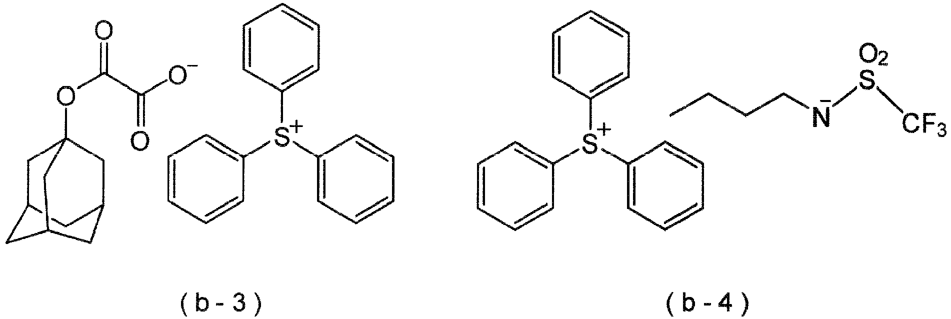

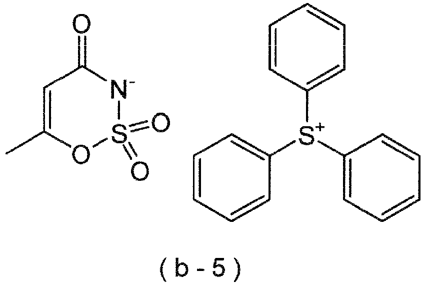

Of these, the photolabile base (B) is preferably a sulfonium salt, more preferably a triarylsulfonium salt, still more preferably a triphenylsulfonium salt, and particularly preferably a compound represented by the above formula (b-1), (b-2) or (b-5).

Note that, as the photolabile base (B), a compound other than the compounds described above may be used as long as it does not substantially dissociate the acid-labile group of the polymer (A) under a condition of a temperature of 110 °C and a time period of 1 min. As such other photolabile base (B), for example, a sulfonium salt formed from: the radiation-sensitive monovalent onium cation represented by S⁺ described above; and an anion represented by R^{γ}-SO3⁻ may be used, wherein R^{γ} represents a monovalent organic group having 1 to 20 carbon atoms. The monovalent organic group represented by R^{γ} is exemplified by a monovalent aliphatic hydrocarbon group, as well as a group that includes at least one of -O-, -CO- and -COO- between two adjacent carbon atoms of the monovalent aliphatic hydrocarbon group, and the like. Specific examples of the monovalent organic group represented by R^{γ} include monovalent groups, alkyl groups and the like that each include at least one ring structure of: a cycloalkane structure such as a cyclopentane structure; a 1,7,7-trimethylbicyclo[2.2.1]heptan-2-one structure; an aliphatic heterocyclic structure such as a norbornanelactone structure; and a bridged hydrocarbon structure such as a norbornane structure. Specific examples of the other photolabile base (B) include compounds represented by the following formulae, and the like.

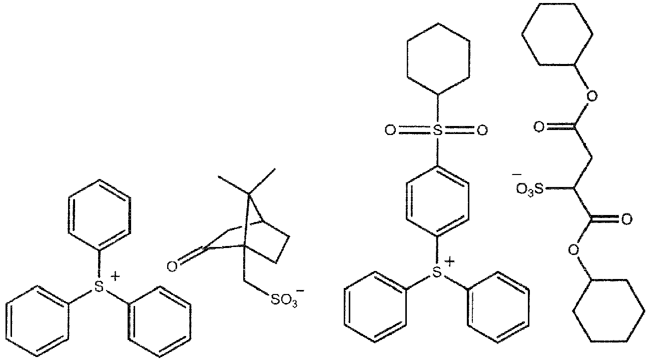

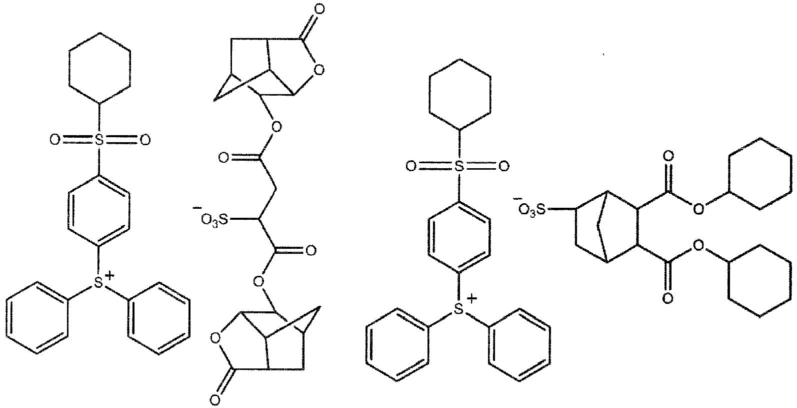

The lower limit of the content of the photolabile base (B) with respect to 100 parts by mass of the polymer (A) is preferably 0.1 parts by mass, more preferably 0.5 parts by mass, and still more preferably 1.5 parts by mass. Meanwhile, the upper limit of the content of the photolabile base (B) is preferably 20 parts by mass, more preferably 10 parts by mass, and still more preferably 5 parts by mass. When the content of the photolabile base (B) falls within the above range, the sensitivity and LWR performance of the radiation-sensitive composition can be more improved.

### (C) Acid Generator

The acid generator (C) is a compound that generates the acid (2) upon an irradiation with a radioactive ray, and the acid (2) allows dissociation of the acid-labile group under a condition of a temperature of 110 °C and a time period of 1 min. Due to the acid (2) thus generated, the acid-labile group included in the polymer (A), etc., is dissociated to produce a carboxy group, a hydroxy group or the like, leading to a change of solubility in a developer solution of the polymer (A), etc., whereby resist pattern formation from the radiation-sensitive composition can be promoted. The acid generator (C) may be contained in the radiation-sensitive composition in the form of a low-molecular-weight compound (hereinafter, may be also referred to as "(C) acid generating agent" or "acid generating agent (C)") or in the form incorporated as a part of the polymer, or may be in both of these forms. The acid generator (C) may be used either alone of one type, or in combination of two or more types thereof.

The compound that can be used as the acid generator (C) may be appropriately selected in accordance with the acid-labile group included in the polymer (A), and a case in which the polymer (A) has the structural unit (I-1), i.e., a case in which the polymer (A) has the acid-labile group represented by -CR¹⁵R¹⁶R¹⁷ in the above formula (2) is specifically described as an example in the following.

The acid (2) generated from the acid generator (C) is exemplified by a sulfonic acid, an imidic acid, and the like.

The acid generating agent (C) is exemplified by an onium salt compound, an N-sulfonyloxyimide compound, a sulfonimide compound, a halogen-containing compound, a diazo ketone compound, and the like.

Exemplary onium salt compound includes a sulfonium salt, a tetrahydrothiophenium salt, an iodonium salt, a phosphonium salt, a diazonium salt, a pyridinium salt, and the like.

Specific examples of the acid generating agent (C) include compounds disclosed in paragraphs [0080] to [0113] of Japanese Unexamined Patent Application, Publication No. 2009-134088, and the like.

Examples of the acid generating agent (C) include a compound represented by the following formula (4), and the like.

A⁻ T⁺ (4)

In the above formula (4), A⁻ represents a monovalent sulfonic acid anion or a monovalent imidic acid anion; and T⁺ represents a radiation-sensitive monovalent onium cation.

Examples of the radiation-sensitive monovalent onium cation represented by T⁺ include cations similar to those exemplified for the radiation-sensitive monovalent onium cation represented by S⁺ in the above formula (B), and the like.

The compound represented by the above formula (4) is exemplified by compounds (hereinafter, may be also referred to as "compounds (d-1) to (d-2)") represented by the following formulae (r1) to (r2), and the like. When any of the compounds (d-1) to (d-2) is used as the acid generating agent (C), it is expected that a diffusion length of the acid (2), which was generated upon the exposure, in the film would be properly reduced through e.g., an interaction of the polymer component (A) with the structural unit (I), or the like, and as a result, the LWR performance and the like of the radiation-sensitive composition are more improved.

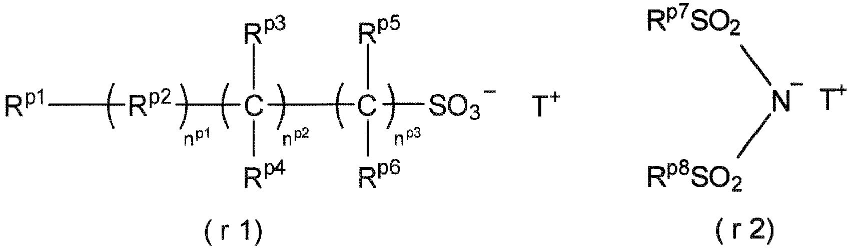

In the above formulae (r1) to (r2), T⁺ is as defined in the above formula (4).

In the above formula (r1), R^{p1} represents a monovalent organic group that includes a ring structure having no less than 5 ring atoms; R^{p} represents a divalent linking group; R^{p3} and R^{p4} each independently represent a hydrogen atom, a fluorine atom, a monovalent hydrocarbon group having 1 to 20 carbon atoms or a monovalent fluorinated hydrocarbon group having 1 to 20 carbon atoms; R^{p5} and R^{p6} each independently represent a hydrogen atom, a fluorine atom or a monovalent fluorinated hydrocarbon group having 1 to 20 carbon atoms, wherein at least one of a pair of R^{p5} and R^{p6} substituting at the carbon atom adjacent to -SO₃⁻ is a fluorine atom; n^{p1} is an integer of 0 to 10; n^{p2} is an integer of 0 to 10; and n^{p3} is an integer of 0 to 10, wherein in a case in which n^{p1} is no less than 2, a plurality of R^{p2}s may be identical or different, in a case in which n^{p2} is no less than 2, a plurality of R^{p3}s may be identical or different and a plurality of R^{p4}s may be identical or different, and in a case in which n^{p3} is no less than 2, a plurality of R^{p5}s may be identical or different and a plurality of R^{p6}s may be identical or different.

In the above formula (r2), R^{p7} and R^{p8} each independently represent a monovalent organic group having 1 to 20 carbon atoms, wherein at least one of R^{p7} and R^{p8} bonds to - SO₂- at the carbon atom substituted with one or a plurality of fluorine atoms, and at least one of R^{p7} and R^{p8} includes a ring structure.

The number of "ring atoms" as referred to means the number of atoms constituting the ring in an alicyclic structure, an aromatic ring structure, an aliphatic heterocyclic structure or an aromatic heterocyclic structure, and in the case of a polycyclic ring structure, the number of "ring atoms" means the number of atoms constituting the polycyclic ring.

The monovalent organic group that includes a ring structure which may be represented by R^{p1}, R^{p7} or R^{p8} is exemplified by a monovalent organic group that includes: a monocyclic structure having no less than 5 ring atoms; a condensed ring structure having no less than 7 ring atoms; a bridged ring structure having no less than 7 ring atom; or a combination thereof, and the like. Of these, a monovalent organic group that includes a condensed ring structure having no less than 7 ring atoms, and a monovalent organic group that includes a bridged ring structure having no less than 7 ring atoms are preferred, and a monovalent organic group that includes a bridged ring structure having no less than 7 ring atoms is more preferred.

Examples of the monocyclic structure having no less than 5 ring atoms include:
monocyclic alicyclic structures such as a cyclopentane structure, a cyclohexane structure, a cycloheptane structure, a cyclooctane structure, a cyclononane structure, a cyclodecane structure, a cyclododecane structure, a cyclopentene structure, a cyclohexene structure, a cycloheptene structure, a cyclooctene structure and a cyclodecene structure;
monocyclic aliphatic heterocyclic structures such as a hexanolactone structure, a hexanosultone structure, an oxacycloheptane structure, a monocyclic acetal structure having no less than 5 ring atoms, an azacyclohexane structure and a thiacyclohexane structure;
monocyclic aromatic ring structures such as a benzene structure;
monocyclic aromatic heterocyclic structures such as a furan structure, a pyridine structure and a pyrimidine structure; and the like.

Examples of the condensed ring structure having no less than 7 ring atoms include:
condensed alicyclic structures such as a tricyclodecane structure, a tetracyclododecane structure, a tricyclodecene structure and a tetracyclododecene structure;
polycyclic aromatic ring structures such as a naphthalene structure, a phenanthrene structure and an anthracene structure;
polycyclic aromatic heterocyclic structures such as a benzopyran structure and an indole structure; and the like.

Examples of the bridged ring structures having no less than 7 ring atoms include:
bridged cyclic hydrocarbon structures such as a norbornane structure, an adamantane structure and a norbornene structure;
bridged aliphatic heterocyclic structures such as a norbornanelactone structure, a norbornanesultone structure, an oxanorbornane structure, a diazabicyclooctane structure and a thianorbornane structure; and the like.

The lower limit of the number of the ring atoms in the ring structure included in R^{p1}, R^{p7} or R^{p8} is preferably 6, more preferably 7, still more preferably 8, and particularly preferably 9. Meanwhile, the upper limit of the number of the ring atoms is preferably 15, more preferably 14, still more preferably 13, and particularly preferably 12. When the number of the ring atoms falls within the above range, the aforementioned diffusion length of the acid (2) may be further properly reduced, and as a result, more improvements of the LWR performance, etc., of the radiation-sensitive composition are enabled.

As the ring structure included in R^{p1}, R^{p7} or R^{p8}, ring structures represented by the following formulae (Z-1) to (Z-4) are preferred, and ring structures represented by the following formulae (Z-1) to (Z-2) are more preferred.

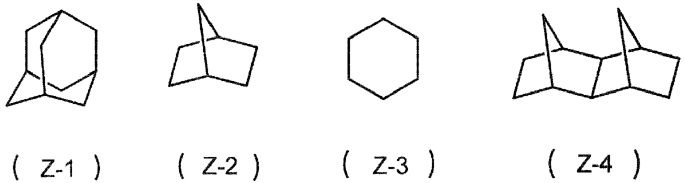

A substituent may be bonded to the carbon atom constituting the ring structure included in R^{p1}, R^{p7} or R^{p8}. Examples of the substituent include alkyl groups, as well as halogen atoms such as a fluorine atom, a chlorine atom, a bromine atom and an iodine atom, a hydroxy group, a carboxy group, a cyano group, a nitro group, an alkoxy group, an alkoxycarbonyl group, an alkoxycarbonyloxy group, an acyl group, an acyloxy group and other hetero atom-containing groups, and the like.

Examples of the divalent linking group represented by R^{p2} include a carbonyl group, an ether group, a carbonyloxy group, a sulfide group, a thiocarbonyl group, a sulfonyl group, a divalent hydrocarbon group, and the like. As the divalent linking group represented by R^{p2}, the carbonyloxy group, the sulfonyl group, an alkanediyl group and a divalent alicyclic saturated hydrocarbon group are preferred, the carbonyloxy group and the divalent alicyclic saturated hydrocarbon group are more preferred, the carbonyloxy group and a norbornanediyl group are still more preferred, and the carbonyloxy group is particularly preferred.

The monovalent hydrocarbon group having 1 to 20 carbon atoms which may be represented by R^{p3} or R^{p4} is exemplified by an alkyl group having 1 to 20 carbon atoms, and the like. The monovalent fluorinated hydrocarbon group having 1 to 20 carbon atoms which may be represented by R^{p3} or R^{p4} is exemplified by a fluorinated alkyl group having 1 to 20 carbon atoms, and the like. R^{p3} and R^{p4} each independently represent preferably a hydrogen atom, a fluorine atom or a fluorinated alkyl group, more preferably a fluorine atom or a perfluoroalkyl group, and still more preferably a fluorine atom or a trifluoromethyl group.

The monovalent fluorinated hydrocarbon group having 1 to 20 carbon atoms which may be represented by R^{p5} or R^{p6} is exemplified by a fluorinated alkyl group having 1 to 20 carbon atoms, and the like. R^{p5} and R^{p6} each independently represent preferably a fluorine atom or a fluorinated alkyl group, more preferably a fluorine atom or a perfluoroalkyl group, still more preferably a fluorine atom or a trifluoromethyl group, and particularly preferably a fluorine atom.

In the above formula (r1), n^{p1} is preferably an integer of 0 to 5, more preferably an integer of 0 to 3, still more preferably an integer of 0 to 2, and particularly preferably 0 or 1.

In the above formula (r1), n^{p2} is preferably an integer of 0 to 5, more preferably an integer of 0 to 2, still more preferably 0 or 1, and particularly preferably 0.

In the above formula (r1), n^{p3} is preferably an integer of 1 to 5, and more preferably 1.

Specific examples of the acid generating agent (C) include compounds (hereinafter, may be also referred to as "compounds (d-1-1) to (d-1-18)") represented by the following formulae (r1-1) to (r1-18), a compound (hereinafter, may be also referred to as "compound (d-2-1)") represented by the following formula (r2-1), and the like.

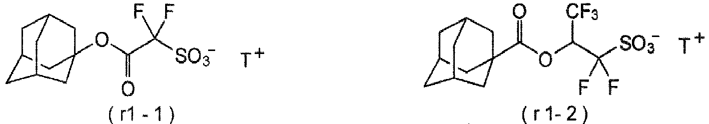

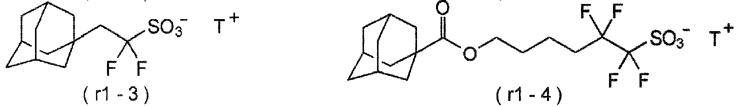

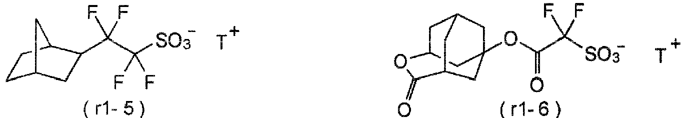

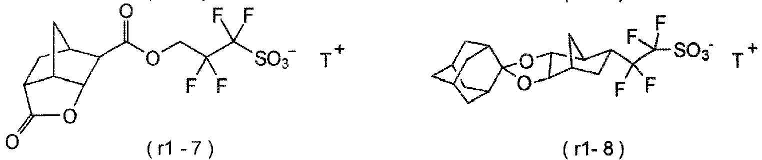

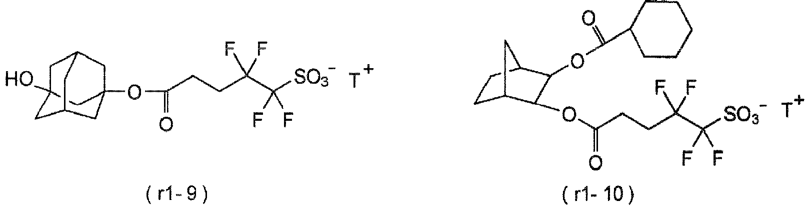

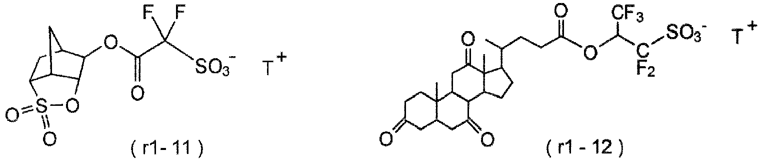

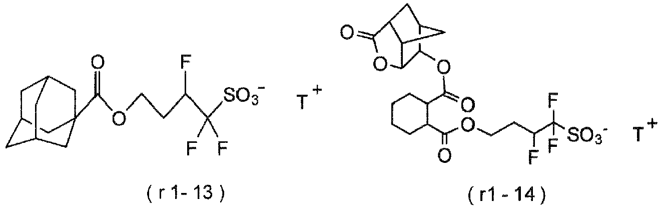

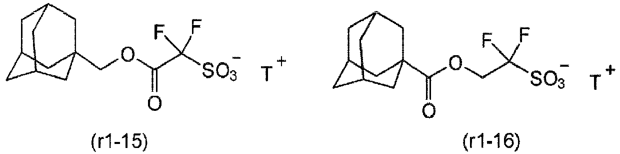

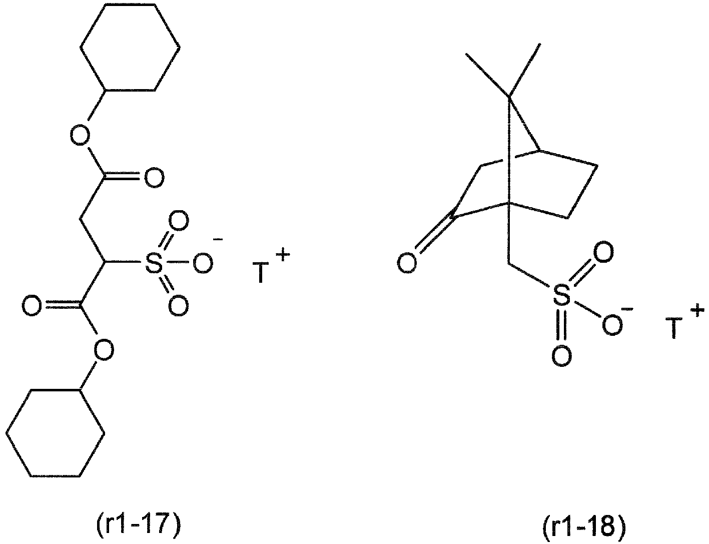

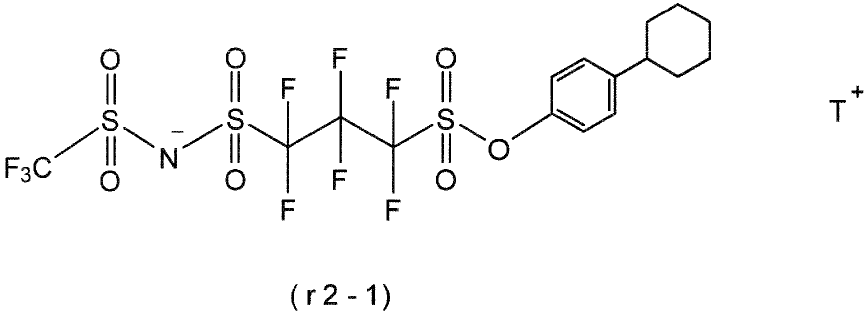

In the above formulae (r1-1) to (r1-18) and (r2-1), T⁺ represents a radiation-sensitive monovalent onium cation.

As the acid generating agent (C), the compounds (d-1-8), (d-1-12) and (d-1-14) to (d-1-18) are preferred.

In a case in which the radiation-sensitive composition contains the acid generating agent (C), the lower limit of the content of the acid generating agent (C) with respect to 100 parts by mass of the polymer (A) is preferably 1 part by mass, more preferably 5 parts by mass, still more preferably 10 parts by mass, and particularly preferably 20 parts by mass. The upper limit of the content of the acid generating agent (C) is preferably 50 parts by mass, more preferably 40 parts by mass, and still more preferably 35 parts by mass. When the content of the acid generating agent (C) falls within the above range, the sensitivity of the radiation-sensitive composition is more improved and developability is improved, and as a result, the LWR performance, etc. can be more improved.

### (D) Iodine-Containing Compound

The iodine-containing compound (D) is a compound other than the photolabile base (B) and the acid generating agent (C), and includes a monovalent iodine atom. In a case in which the polymer (A) has the structural unit (II), the iodine-containing compound (D) is an optional component in the radiation-sensitive composition. Meanwhile, in a case in which the polymer (A) does not have the structural unit (II), the iodine-containing compound (D) is an essential component in the radiation-sensitive composition. In the radiation-sensitive composition, the iodine-containing compound (D) may be used either alone of one type, or in combination of two or more types thereof.

The lower limit of the molecular weight of the iodine-containing compound (D) is preferably 150, and more preferably 200. Meanwhile, the upper limit of the molecular weight is preferably 5,000, more preferably 2,000, and still more preferably 1,000. When the molecular weight of the iodine-containing compound (D) falls within the above range, the sensitivity and LWR performance of the radiation-sensitive composition can be more improved. In a case in which the iodine-containing compound (D) is a polymer, the molecular weight of the iodine-containing compound (D) as referred to herein means weight average molecular weight.

The number of monovalent iodine included in the iodine-containing compound (D) is preferably no less than 1 and no greater than 10, more preferably no less than 1 and no greater than 5, and still more preferably no less than 1 and no greater than 3.

It is preferred that the iodine-containing compound (D) further has a hydroxy group bonding to an aromatic ring.

The iodine-containing compound (D) is exemplified by a compound represented by the following formula (Y-1), and the like.

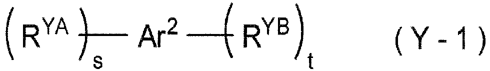

In the above formula (Y-1), Ar² represents a group obtained by removing (s + t) hydrogen atoms from an unsubstituted arene having 6 to 20 carbon atoms; R^{YA} represents a monovalent iodine atom, an iodinated alkyl group having 1 to 20 carbon atoms or an iodinated alkoxy group having 1 to 20 carbon atoms; R^{YB} represents a hydroxy group, a fluorine atom, a chlorine atom, -NH₂ or a monovalent organic group having 1 to 20 carbon atoms; s is an integer of 1 to 10; and t is an integer of 0 to 10, wherein in a case in which s is no less than 2, a plurality of R^{YA}s may be identical or different, and in a case in which t is no less than 2, a plurality of R^{YB}s may be identical or different.

Examples of the unsubstituted arene in connection with Ar² include benzene, naphthalene, anthracene, indene, indane, acenaphthylene, fluorene, phenanthrene, and the like, and of these, benzene is preferred.

The upper limit of the number of carbon atoms of the iodinated alkyl group or the iodinated alkoxy group which may be represented by R^{YA}, and the monovalent organic group which may be represented by R^{YB} is preferably 10, more preferably 5, and still more preferably 3.

The number of the monovalent iodine atom in the iodinated alkyl group or the iodinated alkoxy group which may be represented by R^{YA} is preferably no less than 1 and no greater than 3, and more preferably 1.

Examples of the monovalent organic group which may be represented by R^{YB} include groups similar to those exemplified for the monovalent organic group which may be represented by R^{XB} in the above formula (X), and the like. Specific examples of the monovalent organic group which may be represented by R^{YB} include an alkyl group, an alkoxy group, an acyl group, an alkoxycarbonyl group, and the like, and of these, a methyl group, a methoxy group, an acetyl group and a methoxycarbonyl group are preferred.

The upper limit of s and t is preferably 5, and more preferably 3. Furthermore, the upper limit of the sum of s and t is preferably 10, and more preferably 5.

The iodine-containing compound (D) is also exemplified by compounds represented by the following formulae (Y-2) to (Y-3), and the like.

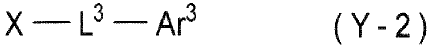

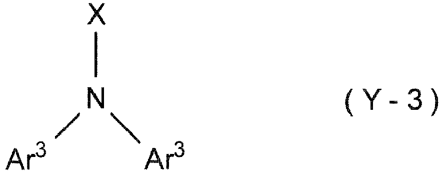

In the above formulae (Y-2) and (Y-3), Xs are each independently represent a monovalent group represented by the above formula (X); and Ar³s each independently represent a substituted or unsubstituted aryl group having 6 to 20 carbon atoms.

In the above formula (Y-2), L³ represents a single bond, an ethenediyl group or a benzenediyl group.

Examples of the aryl group which may be represented by Ar³ include unsubstituted aryl groups such as a phenyl group, a naphthyl group, an anthracenyl group, an indenyl group, an indanyl group, an acenaphthylenyl group, a fluorenyl group and a phenanthrenyl group, as well as substituted aryl groups obtained by substituting a part or all of hydrogen atoms included in the unsubstituted aryl group, and the like.

Examples of the substituent in the substituted aryl group include groups similar to the monovalent group represented by R^{XB} in the above formula (X), and the like.

The substituted aryl group which may be represented by Ar³ may be the monovalent group represented by the above formula (X).

Specific examples of the iodine-containing compound (D) include compounds represented by the following formulae, and the like.

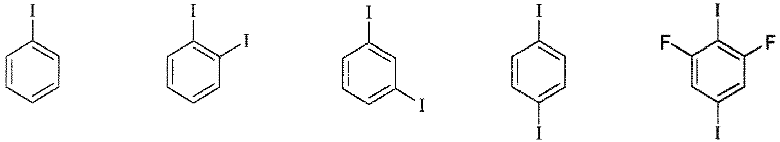

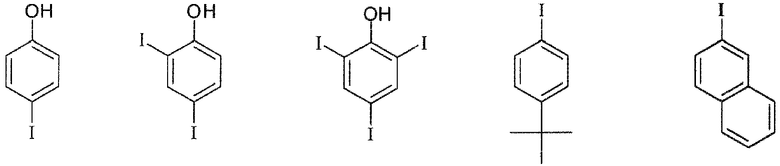

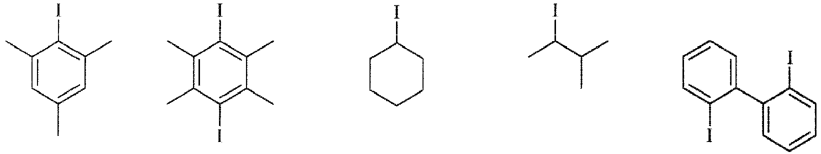

In a case in which the radiation-sensitive composition contains the iodine-containing compound (D), the lower limit of the content of the iodine-containing compound (D) with respect to 100 parts by mass of the polymer (A) is preferably 1 part by mass, more preferably 3 parts by mass, and still more preferably 7 parts by mass. Meanwhile, the upper limit of the content of the iodine-containing compound (D) is preferably 30 parts by mass, more preferably 20 parts by mass, and still more preferably 15 parts by mass. When the content of the iodine-containing compound (D) falls within the above range, the sensitivity and LWR performance of the radiation-sensitive composition may be more improved.

### (E) Solvent

The solvent (E) is not particularly limited as long as it is a solvent capable of dissolving or dispersing the polymer (A), the photolabile base (B) and the acid generator (C), as well as the optional component(s) such as the iodine-containing compound (D) which may be contained as desired. In the radiation-sensitive composition, the solvent (E) may be used either alone of one type, or in combination of two or more types thereof.

The solvent (E) is exemplified by an alcohol solvent, an ether solvent, a ketone solvent, an amide solvent, an ester solvent, a hydrocarbon solvent, and the like.

Examples of the ester solvent include:
monocarboxylic acid ester solvents such as n-butyl acetate and ethyl lactate;
polyhydric alcohol carboxylate solvents such as propylene acetate glycol;
polyhydric alcohol partially etherated carboxylate solvents such as propylene glycol monomethyl ether acetate;
polyhydric carboxylic acid diester solvents such as diethyl oxalate;
carbonate solvents such as dimethyl carbonate and diethyl carbonate; and the like.

Specific examples of the solvent (E) include solvents disclosed in paragraph [0164] to paragraph [0169] of Japanese Unexamined Patent Application, Publication No. 2016-173513, and the like.

As the solvent (E), the ester solvents are preferred, the monocarboxylic acid ester solvents and the polyhydric alcohol partially etherated carboxylate solvents are more preferred, and ethyl lactate and propylene glycol monomethyl ether acetate are still more preferred.

### (F) Acid Diffusion Control Agent

The acid diffusion control agent (F) is a compound other than the iodine-containing compound (D), and controls a diffusion phenomenon in the film, of the acid generated from the acid generator (C), etc., upon an exposure, thereby inhibiting unfavorable chemical reactions at light-unexposed regions. In addition, the acid diffusion control agent (F) improves storage stability and resolution of the radiation-sensitive composition. Furthermore, the acid diffusion control agent (F) inhibits variation of the line width of the resist pattern caused by variation of post exposure time delay from the exposure until a development treatment of the radiation-sensitive composition, whereby the process stability may be improved. The acid diffusion control agent (F) may be contained in the radiation-sensitive composition in the form of a free compound (hereinafter, may be referred to as "(F) acid diffusion control agent" as appropriate) or in the form incorporated as a part of the polymer, or in both of these forms. The radiation-sensitive composition may contain the acid diffusion control agent (F) either alone of one type, or in combination of two or more types thereof.

The acid diffusion control agent (F) is exemplified by: a compound having one nitrogen atom such as monoalkylamine; a compound having two nitrogen atoms such as ethylene diamine; a compound having three or more nitrogen atoms such as polyethylene imine; an amide group-containing compound such as N,N-dimethylacetamide; a urea compound such as 1,1,3,3-tetramethylurea; a nitrogen-containing heterocyclic compound such as N-(undecylcarbonyloxyethyl)morpholine or N-t-butoxycarbonyl-4-hydroxypiperidine; and the like.

In a case in which the radiation-sensitive composition contains the acid diffusion control agent (F), the lower limit of the content of the acid diffusion control agent (F) with respect to 100 parts by mass of the polymer (A) is preferably 0.01 parts by mass, more preferably 0.1 parts by mass, and still more preferably 0.3 parts by mass. Meanwhile, the upper limit of the content of the acid diffusion control agent (F) is preferably 5 parts by mass, more preferably 3 parts by mass, and still more preferably 1 part by mass.

### Optional Component

The radiation-sensitive composition may further contain other optional component(s) such as a fluorine atom-containing polymer, a localization accelerator and/or a surfactant, in addition to the components (A) to (F) described above. In the radiation-sensitive composition, the other optional component may be each used either alone of one type, or in combination of two or more types thereof.

The fluorine atom-containing polymer is a polymer having a percentage content by mass of fluorine atoms greater than that of the polymer (A). Due to having the percentage content by mass of fluorine atoms greater than that of the polymer (A), the fluorine atom-containing polymer has higher hydrophobicity, and by virtue of characteristics resulting from the hydrophobicity, the fluorine atom-containing polymer tends to be localized in the surface layer of the film. As a result, due to containing the fluorine atom-containing polymer, the radiation-sensitive composition enables elution of the acid generating agent (C), the acid diffusion control agent (F), etc., into a liquid immersion medium to be inhibited in liquid immersion lithography. In addition, by controlling an advancing contact angle of a liquid immersion medium on the film to fall within a desired range, inhibition of generation of bubble defects is enabled. Furthermore, due to the radiation-sensitive composition containing the fluorine atom-containing polymer, a greater receding contact angle of the liquid immersion medium on the resist film is attained, whereby an exposure by high speed scanning without being accompanied by residual water beads is enabled. Thus, when the radiation-sensitive composition contains the fluorine atom-containing polymer, a film suitable for liquid immersion lithography processes can be provided.

In a case in which the radiation-sensitive composition contains the fluorine atom-containing polymer, the lower limit of the content of the fluorine atom-containing polymer with respect to 100 parts by mass of the polymer (A) is preferably 0.1 parts by mass, more preferably 0.5 parts by mass, still more preferably 1 part by mass, and particularly preferably 2 parts by mass. Meanwhile, the upper limit of the content of the fluorine atom-containing polymer is preferably 30 parts by mass, more preferably 20 parts by mass, still more preferably 15 parts by mass, and particularly preferably 10 parts by mass.

### Localization Accelerator

The localization accelerator has the effect that for example, in the case of the radiation-sensitive composition of the embodiment of the present invention containing the fluorine atom-containing polymer, the fluorine atom-containing polymer is more efficiently segregated in the surface region of the film. When the radiation-sensitive composition contains the localization accelerator, the amount of the fluorine atom-containing polymer added can be decreased than ever before. Therefore, elution of the component(s) from the film into a liquid immersion medium is further inhibited, and quicker liquid immersion lithography is enabled by high speed scanning, without impairing the LWR performance, etc. As a result, defects caused by the liquid immersion such as watermark defects can be inhibited. Such a localization accelerator is exemplified by a low molecular weight compound having a relative permittivity of no less than 30 and no greater than 200, and having a boiling point at 1 atmospheric pressure of no less than 100 °C. Specific examples of such a compound include a lactone compound, a carbonate compound, a nitrile compound, a polyhydric alcohol, and the like.

In a case in which the radiation-sensitive composition contains the localization accelerator, the lower limit of the content of the localization accelerator with respect to 100 parts by mass of the polymer (A) is preferably 10 parts by mass, more preferably 15 parts by mass, still more preferably 20 part by mass, and particularly preferably 25 parts by mass. Meanwhile, the upper limit of the content of the localization accelerator is preferably 500 parts by mass, more preferably 300 parts by mass, still more preferably 200 parts by mass, and particularly preferably 100 parts by mass.

### Surfactant

The surfactant achieves the effect of improving the coating characteristics, striation, developability, and the like. Examples of the surfactant include nonionic surfactants such as polyoxyethylene lauryl ether, and the like. In a case in which the radiation-sensitive composition contains the surfactant, the upper limit of the content of the surfactant with respect to 100 parts by mass of the polymer (A) is preferably 2 parts by mass.

### Preparation Procedure of Radiation-Sensitive Composition

The radiation-sensitive composition of the embodiment of the present invention may be prepared, for example, by mixing the polymer (A), the photolabile base (B) and the acid generator (C), as well as optional component(s) which may be blended as needed such as the iodine-containing compound (D), the solvent (E) and the acid diffusion control agent (F) at a certain ratio, and preferably filtering a resultant mixture through, for example, a filter, etc., having a pore size of about 0.2 µm. The lower limit of the solid content concentration of the radiation-sensitive composition is preferably 0.1% by mass, more preferably 0.5% by mass, and still more preferably 1% by mass. The upper limit of the solid content concentration is preferably 50% by mass, more preferably 30% by mass, still more preferably 10% by mass, and particularly preferably 5% by mass.

### Resist Pattern-Forming Method

The resist pattern-forming method of the embodiment of the present invention includes: applying the radiation-sensitive composition of the aforementioned embodiment of the invention directly or indirectly on a substrate (applying step); exposing a film formed by the applying (exposure step); and developing the film exposed (development step).

Since the radiation-sensitive composition of the embodiment of the present invention is used, the pattern-forming method enables a pattern accompanied by less LWR to be formed with superior sensitivity being achieved. Each step will be described below.

### Applying Step

In this step, the aforementioned radiation-sensitive composition is applied directly or indirectly on a substrate. A film is formed by this applying step. The substrate on which this film is to be formed is exemplified by conventionally well-known wafers such as, e.g., a silicon wafer, a wafer coated with silicon dioxide or aluminum, and the like. Also, a substrate having an organic or inorganic antireflective film formed thereon beforehand as disclosed in for example, Japanese Examined Patent Application, Publication Nos. H6-12452,. S59-93448 and the like may be used. The application procedure may involve, for example, spin-coating, flow cast coating, roll coating, and the like. After the applying, prebaking (PB) for volatilization of the solvent in the coating film may be carried out as needed. The lower limit of the temperature of PB is preferably 60 °C, and more preferably 80 °C. The upper limit of the temperature is preferably 140 °C, and more preferably 120 °C. The lower limit of the time period of PB is preferably 5 sec, and more preferably 10 sec. The upper limit of the time period is preferably 600 sec, and more preferably 300 sec. The lower limit of the average thickness of the film formed is preferably 10 nm, and more preferably 20 nm. The upper limit of the average thickness is preferably 1,000 nm, and more preferably 500 nm.

In a case of conducting, for example, liquid immersion lithography by using the radiation-sensitive composition not containing the fluorine-containing polymer, a protective film for liquid immersion that is insoluble in the liquid immersion medium may be provided on the formed film, for the purpose of preventing a direct contact of the film with the liquid immersion medium. As the protective film for liquid immersion, either a solvent-peelable protective film that is peeled by a solvent prior to the development step (see Japanese Unexamined Patent Application, Publication No. 2006-227632), or a developer solution-peelable protective film that is peeled concomitant with the development in the development step (see, PCT International Publication Nos. 2005/069076 and 2006/035790) may be used. However, in light of the throughput, a developer solution-peelable protective film for liquid immersion is preferably used.

### Exposure Step

In this step, the film formed by the applying step is exposed. This exposure is carried out by irradiation with an exposure light through a photomask and as necessary, a liquid immersion medium such as water. Examples of the exposure light include electromagnetic waves such as visible light rays, ultraviolet rays, far ultraviolet rays, EUV, X-rays and γ-rays; charged particle rays such as electron beams and α-rays, and the like, which may be selected in accordance with a line width of the intended pattern. Of these, far ultraviolet rays, EUV and an electron beam are preferred; an ArF excimer laser beam (wavelength: 193 nm), a KrF excimer laser beam (wavelength: 248 nm), EUV and an electron beam is more preferred; and an ArF excimer laser beam, EUV and an electron beam are still more preferred.

In a case in which liquid immersion lithography is conducted in this step, examples of the liquid immersion liquid for use in the exposure include water, fluorine-containing inert liquids, and the like. It is preferred that the liquid immersion liquid is transparent to an exposure wavelength, and has a temperature coefficient of the refractive index as small as possible so that distortion of an optical image projected onto the film is minimized. In particular, when an ArF excimer laser beam is used as an exposure light, it is preferred to use water in light of availability and ease of handling thereof in addition to the aforementioned considerations. When water is used, a slight amount of an additive which reduces the surface tension of water and imparts enhanced surfactant power may be added. It is preferred that the additive hardly dissolves the film on a wafer and has a negligible influence on an optical coating of an inferior face of a lens. The water for use is preferably distilled water.

In this step, it is preferred that PEB is carried out after the exposure to promote dissociation of the acid-labile group included in the polymer (A), etc., mediated by the acid generated from the acid generator (C), etc., upon the exposure in exposed regions of the film. This PEB enables a difference in solubility of the resist film in a developer solution between the light-exposed regions and light-unexposed regions to be increased. The lower limit of the temperature for PEB is preferably 50 °C, and more preferably 80 °C. The upper limit of the temperature is preferably 180 °C, and more preferably 130 °C. The lower limit of the time period for PEB is preferably 5 sec, and more preferably 10 sec. The upper limit of the time period is preferably 600 sec, and more preferably 300 sec.

### Development Step

In this step, the resist film exposed is developed. Accordingly, a predetermined resist pattern is formed. After the development, washing with a rinse agent such as water or an alcohol, followed by further drying is typically carried out. The development procedure in the development step may be carried out by either development with an alkali, or development with an organic solvent.

In the case of the development with an alkali, the developer solution for use in the development is exemplified by alkaline aqueous solutions dissolving at least one alkaline compound such as sodium hydroxide, potassium hydroxide, sodium carbonate, sodium silicate, sodium metasilicate, aqueous ammonia, ethylamine, n-propylamine, diethylamine, di-n-propylamine, triethylamine, methyldiethylamine, ethyldimethylamine, triethanolamine, tetramethylammonium hydroxide (TMAH), pyrrole, piperidine, choline, 1,8-diazabicyclo-[5.4.0]-7-undecene, 1,5-diazabicyclo-[4.3.0]-5-nonene, etc., and the like. Of these, an aqueous TMAH solution is preferred, and a 2.38% by mass aqueous TMAH solution is more preferred.

In the case of the development with an organic solvent, the developer solution is exemplified by an organic solvent such as a hydrocarbon solvent, an ether solvent, an ester solvent, a ketone solvent and an alcohol solvent, as well as a solvent containing the organic solvent, and the like. Exemplary organic solvent includes the solvents similar to those exemplified in connection with the solvent (F) for the radiation-sensitive composition, and the like. Of these, the ester solvent and the ketone solvent are preferred. The ester solvent is preferably an acetic acid ester solvent, and more preferably n-butyl acetate. The ketone solvent is preferably a chain ketone, and more preferably 2-heptanone. The lower limit of the content of the organic solvent in the developer solution is preferably 80% by mass, more preferably 90% by mass, still more preferably 95% by mass, and particularly preferably 99% by mass. Components other than the organic solvent in the organic solvent developer solution are exemplified by water, silicone oil, and the like.

Examples of the development procedure include: a dipping procedure in which the substrate is immersed for a given time period in the developer solution charged in a container; a puddle procedure in which the developer solution is placed to form a dome-shaped bead by way of the surface tension on the surface of the substrate for a given time period to conduct a development; a spraying procedure in which the developer solution is sprayed onto the surface of the substrate; a dynamic dispensing procedure in which the developer solution is continuously applied onto the substrate that is rotated at a constant speed while scanning with a developer solution-discharge nozzle at a constant speed; and the like.

### EXAMPLES

Hereinafter, the present invention is explained in detail by way of Examples, but the present invention is not in any way limited to these Examples. Measuring methods for various types of physical properties are shown below.

### Measurement of Mw, Mn and Mw/Mn

Mw and Mn of the polymer were measured by GPC using GPC columns manufactured by Tosoh Corporation ("G2000 HXL" x 2, "G3000 HXL" x 1, and "G4000 HXL" x 1) under the following conditions. A dispersity index (Mw/Mn) was calculated from the results of the measurements of Mw and Mn.
elution solvent: tetrahydrofuran;
flow rate: 1.0 mL/min;
amount of injected sample: 100 µL;
column temperature: 40 °C;
detector: differential refractometer; and
standard substance: mono-dispersed polystyrene

### ¹H-NMR Analysis and ¹³C-NMR Analysis

The proportion of each structural unit contained in each polymer (mol%) was determined by an analysis using "JNM-Delta 400" available from JEOL, Ltd.

### Synthesis of Polymer (A)

Compound (M-1) to (M-18) used as monomers for synthesizing each polymer of Examples and Comparative Examples are shown below.

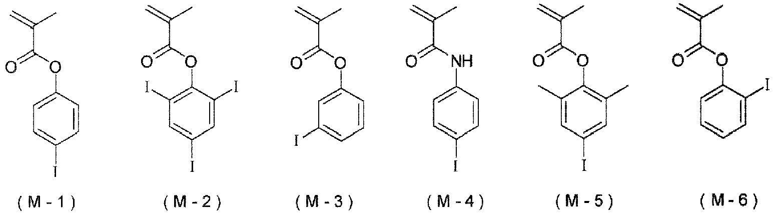

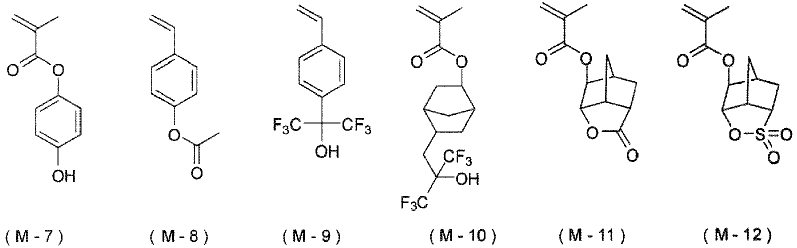

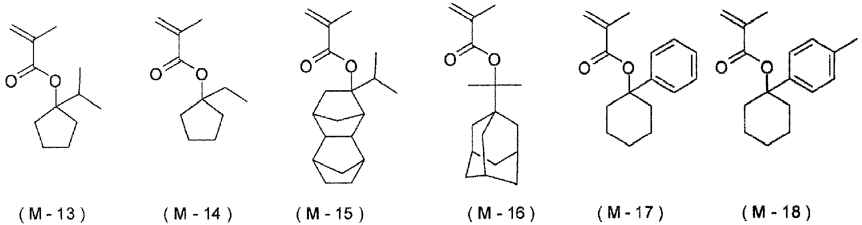

### Synthesis Example 1: Synthesis of Polymer (A-1)

The compound (M-7), the compound (M-13) and the compound (M-1) as monomers in an amount of 33 parts by mass in total were dissolved to give a molar ratio of 35/45/20 in 100 parts by mass of propylene glycol monomethyl ether. A monomer solution was prepared by adding AIBN (with respect to 6 mol% of total monomers) as an initiator, and t-dodecyl mercaptan (38 parts by mass with respect to 100 parts by mass of AIBN) to the mixture. This monomer solution was maintained in a nitrogen atmosphere at a reaction temperature of 70 °C to permit copolymerization for 16 hrs. After the completion of the polymerization reaction, a polymerization solution thus obtained was added dropwise into 1,000 parts by mass of n-hexane, whereby the polymer was purified through solidification. Next, the polymer was filtered off, and the resulting white powder was washed twice with n-hexane and dried at 50 °C for 17 hrs to give a white powdery polymer (A-1) with a favorable yield. The polymer (A-1) had Mw of 6,200, and Mw/Mn of 1.42. As a result of the ¹³C-NMR analysis, proportions of respective structural units derived from the compound (M-7), the compound (M-13) and the compound (M-1) were 35.3 mol%, 43.6 mol% and 21.1 mol%, respectively.

### Synthesis Example 2 and Synthesis Examples 7 to 10: Syntheses of Polymer (A-2) and Polymer (A-7) to Polymer (A-10)

A polymer (A-2), and polymers (A-7) to|(A-10) were synthesized in a similar manner to Synthesis Example 1 except that the type and the amount of the monomer used were as shown in Table 1.

### Synthesis Example 3: Synthesis of Polymer (A-3)

The compound (M-8), the compound (M-15) and the compound (M-3) as monomers in an amount of 33 parts by mass in total were dissolved to give a molar ratio of 35/45/20 in 100 parts by mass of propylene glycol monomethyl ether. A monomer solution was prepared by adding AIBN (with respect to 6 mol% of total monomers) as an initiator, and t-dodecyl mercaptan (38 parts by mass with respect to 100 parts by mass of AIBN) to the mixture. This monomer solution was maintained in a nitrogen atmosphere at a reaction temperature of 70 °C to permit copolymerization for 16 hrs. After the completion of the polymerization reaction, a polymerization solution thus obtained was added dropwise into 1,000 parts by mass of n-hexane, whereby the polymer was purified through solidification. Next, 150 parts by mass of propylene glycol monomethyl ether were added again to the polymer, and then 150 parts by mass of methanol, triethylamine (150 mol% with respect to the amount of the compound (M-8) used) and water (150 mol% with respect to the amount of the compound (M-8) used) were further added thereto. A hydrolysis reaction was allowed while the mixture was refluxed at a boiling point for 8 hrs. Accordingly, the structural unit derived from the compound (M-8) was deprotected, converting the acetoxy group into a phenolic hydroxy group. After the completion of the reaction, the solvent and triethylamine was distilled off under reduced pressure, and a polymer thus obtained was dissolved in 150 parts by mass of acetone. The polymer solution was added dropwise into 2,000 parts by mass of water to permit coagulation, and a produced white powder was filtered off and dried at 50 °C for 17 hrs to give a white powdery polymer (A-3) with a favorable yield. The polymer (A-3) had Mw of 6,600, and Mw/Mn of 1.39. As a result of the ¹³C-NMR analysis, proportions of a p-hydroxystyrene unit (structural unit formed by deprotection of the structural unit derived from the compound (M-8)), and respective structural units derived from the compound (M-15) and the compound (M-3) were 36.3 mol%, 43.3 mol% and 20.4 mol%, respectively.

### Synthesis Examples 4 to 6 and Synthesis Examples 11 to 13: Syntheses of Polymer (A-4) to Polymer (A-6) and Polymer (A-11) to Polymer (A-13)

Polymers (A-4) to (A-6) and polymers (A-11) to (A-13) were synthesized in a similar manner to Synthesis Example 3 except that the type and the amount of the monomer used were as shown in Table 1.

Values of the yield, Mw and Mw/Mn of each polymer obtained are shown together in Table 1. It is to be noted that denotation "-" in the following Table indicates that a corresponding component was not employed.

**Table 1**

| | (A) Polymer | Structural unit (I) | | Structural unit (II) | | Structural unit (III) | | | | Yield (%) | Mw | Mw/Mn |
|---|---|---|---|---|---|---|---|---|---|---|---|---|
| | | type | using amount (mol%) | Type | using amount (mol%) | Type | using amount (mol%) | type | using amount (mol%) | | | |
| Synthesis Example 1 | A-1 | M-13 | 45 | M-1 | 20 | M-7 | 35 | - | - | 73.8 | 6,200 | 1.42 |
| Synthesis Example 2 | A-2 | M-14 | 45 | M-2 | 20 | M-7 | 35 | - | - | 74.0 | 6,100 | 1.41 |
| Synthesis Example 3 | A-3 | M-15 | 45 | M-3 | 20 | M-8 | 35 | - | - | 79.1 | 6,600 | 1.39 |
| Synthesis Example 4 | A-4 | M-16 | 45 | M-4 | 20 | M-8 | 35 | - | - | 72.6 | 6,300 | 1.40 |
| Synthesis Example 5 | A-5 | M-17 | 45 | M-5 | 20 | M-8 | 35 | - | - | 76.2 | 6,100 | 1.37 |
| Synthesis Example 6 | A-6 | M-13 | 45 | M-6 | 20 | M-8 | 35 | - | - | 70.2 | 6,100 | 1.43 |
| Synthesis Example 7 | A-7 | M-14 | 45 | M-2 | 20 | M-9 | 35 | - | - | 75.1 | 6,700 | 1.42 |
| Synthesis Example 8 | A-8 | M-15 | 45 | M-2 | 20 | M-10 | 35 | - | - | 71.9 | 6,200 | 1.53 |
| Synthesis Example 9 | A-9 | M-16 | 45 | M-2 | 20 | M-11 | 35 | - | - | 72.1 | 6,000 | 1.51 |
| Synthesis Example 10 | A-10 | M-17 | 45 | M-2 | 20 | M-12 | 35 | - | - | 71.9 | 6,200 | 1.40 |
| Synthesis Example 11 | A-11 | M-18 | 45 | M-2 | 20 | M-8 | 20 | M-10 | 15 | 75.7 | 6,300 | 1.39 |
| Synthesis Example 12 | A-12 | M-18 | 45 | - | - | M-8 | 35 | M-12 | 20 | 71.2 | 6,300 | 1.44 |
| Synthesis Example 13 | A-13 | M-18 | 45 | - | - | M-8 | 35 | M-10 | 20 | 72.2 | 6,900 | 1.38 |

### Preparation of Radiation-Sensitive Composition

Components other than the polymer (A) constituting the radiation-sensitive composition are shown below.

### (B) Photolabile Base

As the photolabile base (B), compounds represented by the following formulae (B-1) to (B-3) were used.

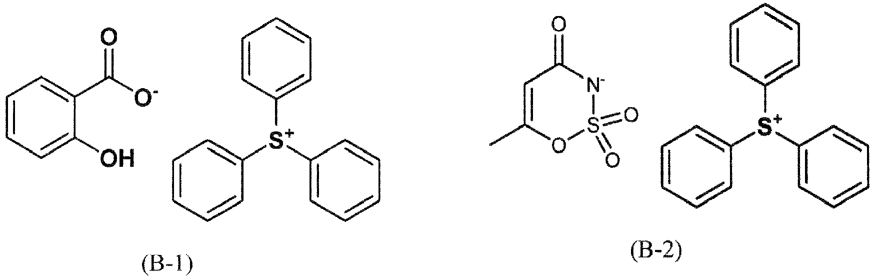

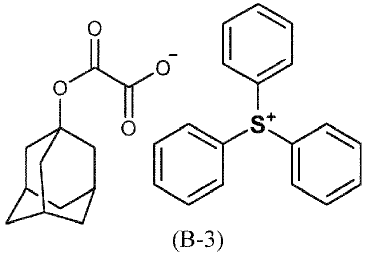

### (C) Acid Generating Agent

As the acid generating agent (C), compounds represented by the following formulae (C-1) to (C-7) were used.

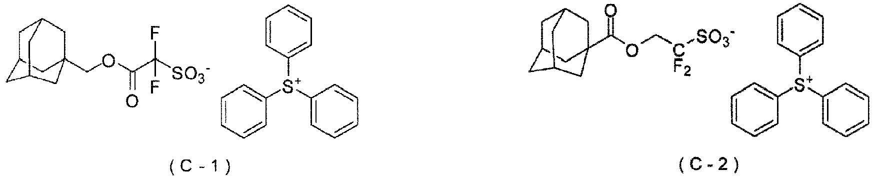

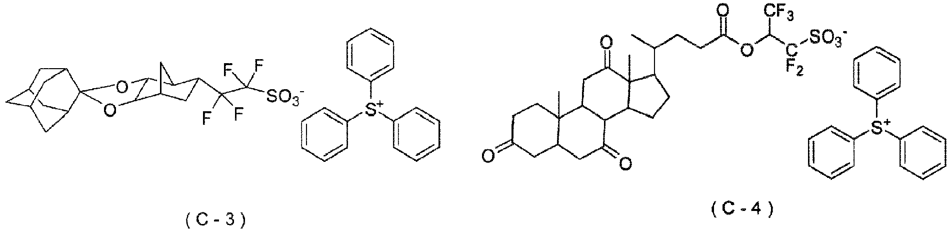

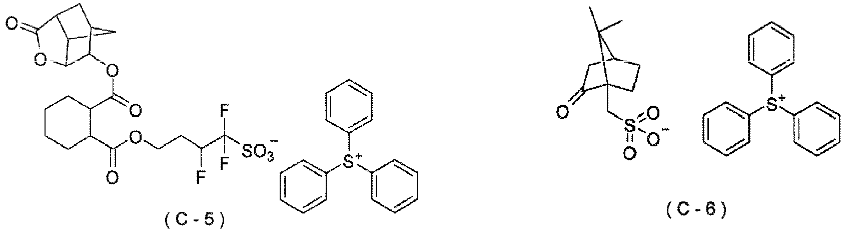

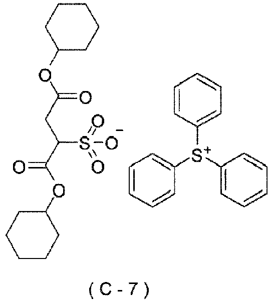

### (D) Iodine-Containing Compound

As the iodine-containing compound (D), compounds represented by the following formulae (D-1) to (D-3) were used.

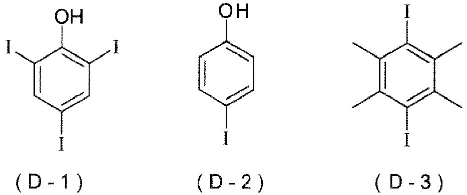

### (E) Solvent

As the solvent (E), the following compounds were used.

### E-1: propylene glycol monomethyl ether acetate

### E-2: ethyl lactate

### (F) Acid Diffusion Control Agent

As the acid generating agent (F), a compound represented by the following formula (F-1) was used.

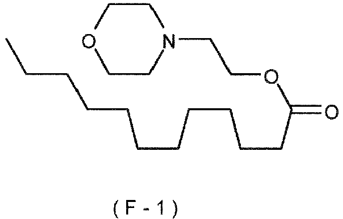

### Example 1

A radiation-sensitive composition (J-1) was prepared by: mixing 100 parts by mass of (A-1) as the polymer (A), 3 parts by mass of (B-1) as the photolabile base (B), 25 parts by mass of (C-1) as the acid generating agent (C), and 4,280 parts by mass of (E-1) and 1,830 parts by mass of (E-2) as the solvent (E); and filtering the mixture through a membrane filter having a pore size of 0.2 µm.

### Examples 2 to 15 and Comparative Examples 1 to 4

Radiation-sensitive compositions (J-2) to (J-15) and (K-1) to (K-4) were prepared in a similar manner to Example 1 except that each component of the type and the content shown in Table 2 below was used.

**Table 2**

| | Radiation-sensitive composition | (A) Polymer | | (B) Photolabile base | | (C) Acid generating agent | | (D) Iodine-containing compound | | (E) Solvent | | (F) Acid diffusion control agent | |
|---|---|---|---|---|---|---|---|---|---|---|---|---|---|
| | | type | content (parts by mass) | type | content (parts by mass) | type | content (parts by mass) | type | content (parts by mass) | type | content (parts by mass) | type | content (parts by mass) |
| Example 1 | J-1 | A-1 | 100 | B-1 | 3 | C-1 | 25 | - | - | E-1/E-2 | 4280/1830 | - | - |
| Example 2 | J-2 | A-2 | 100 | B-2 | 3 | C-2 | 25 | - | - | E-1/E-2 | 4280/1830 | - | - |
| Example 3 | J-3 | A-3 | 100 | B-3 | 3 | C-3 | 25 | - | - | E-1/E-2 | 4280/1830 | - | - |
| Example 4 | J-4 | A-4 | 100 | B-1 | 3 | C-4 | 25 | - | - | E-1/E-2 | 4280/1830 | - | - |
| Example 5 | J-5 | A-5 | 100 | B-1 | 3 | C-5 | 25 | - | - | E-1/E-2 | 4280/1830 | - | - |
| Example 6 | J-6 | A-6 | 100 | B-1 | 3 | C-6 | 25 | - | - | E-1/E-2 | 4280/1830 | - | - |
| Example 7 | J-7 | A-7 | 100 | B-1 | 3 | C-7 | 25 | - | - | E-1/E-2 | 4280/1830 | - | - |
| Example 8 | J-8 | A-8 | 100 | B-1 | 3 | C-1 | 25 | - | - | E-1/E-2 | 4280/1830 | - | - |
| Example 9 | J-9 | A-9 | 100 | B-1 | 2 | C-2 | 25 | - | - | E-1/E-2 | 4280/1830 | F-1 | 0.5 |
| Example 10 | J-10 | A-10 | 100 | B-1 | 2 | C-3 | 25 | - | - | E-1/E-2 | 4280/1830 | F-1 | 0.5 |
| Example 11 | J-11 | A-11 | 100 | B-1 | 2 | C-4 | 25 | - | - | E-1/E-2 | 4280/1830 | F-1 | 0.5 |
| Example 12 | J-12 | A-2 | 100 | B-1 | 3 | C-1 | 25 | - | - | E-1/E-2 | 4280/1830 | - | - |
| Example 13 | J-13 | A-2 | 90 | B-1 | 3 | C-1 | 25 | D-1 | 10 | E-1/E-2 | 4280/1830 | - | - |
| Example 14 | J-14 | A-12 | 90 | B-1 | 3 | C-1 | 25 | D-2 | 10 | E-1/E-2 | 4280/1830 | - | - |
| Example 15 | J-15 | A-12 | 90 | B-1 | 3 | C-1 | 25 | D-3 | 10 | E-1/E-2 | 4280/1830 | - | - |
| Comparative Example 1 | K-1 | A-2 | 100 | - | - | C-1 | 25 | - | - | E-1/E-2 | 4280/1830 | F-1 | 1.8 |
| Comparative Example 2 | K-2 | A-12 | 100 | B-1 | 3 | C-1 | 25 | - | - | E-1/E-2 | 4280/1830 | - | - |
| Comparative Example 3 | K-3 | A-13 | 100 | B-1 | 3 | C-1 | 25 | - | - | E-1/E-2 | 4280/1830 | - | - |
| Comparative Example 4 | K-4 | A-13 | 100 | - | - | C-1 | 25 | - | - | E-1/E-2 | 4280/1830 | F-1 | 1.8 |

The test described above revealed that in each composition: the acid (1) generated from the photolabile base (B) does not substantially dissociate the acid-labile group of the polymer (A) under a condition of a temperature of 110 °C and a time period of 1 min; and the acid (2) generated from the acid generating agent (C) dissociates the acid-labile group of the polymer (A) under a condition of a temperature of 110 °C and a time period of 1 min.

### Resist Pattern Formation

### Formation of Film

On a 6-inch Si wafer which had been subjected to a hexamethyldisilazane (HMDS) treatment beforehand, each radiation-sensitive composition solution was applied by using a spin coater ("Mark 8" available from Tokyo Electron Limited) and dried at 100 °C for 60 sec on a hot plate to give a wafer provided with a film having an average thickness of 50 nm.

### EUV-Exposure and Development

The wafer provided with the film was subjected to a patterning light-exposure by an EUV-exposure system ("Micro Exposure Tool" available from Exitech Ltd., NA: 0.3, Quadrupole, outer Sigma: 0.68, inner Sigma: 0.36) with an exposure mask (line/ pace = 1/1). After the exposure, the wafer provided with the film was heated on a hot plate at 110 °C for 60 sec, and then immersed with a 2.38% by mass aqueous TMAH solution for 60 sec. Following the immersion, the wafer was rinsed with water for 30 sec and then dried to give a resist pattern composed of a 1:1 line-and-space pattern with a line width of 50 nm.

### Evaluations

The sensitivity and the LWR performance of each radiation-sensitive composition were evaluated on the basis of observation results of the resist pattern by using a scanning electron microscope ("S-9380II" available from Hitachi, Ltd.). The results of the evaluations are shown in Table 3.

### Sensitivity

The sensitivity was evaluated on the basis of an optimum exposure dose (Eop) being an exposure dose (mJ) at which resolution of a 1:1 line-and-space pattern with a line width of 50 nm was enabled when the aforementioned resist pattern-formation was performed with varying exposure doses. A smaller Eop value indicates more favorable sensitivity.

### LWR Performance

On a line-and-space pattern formed through an exposure with the exposure dose corresponding to Eop, observation was carried out from above the pattern using the scanning electron microscope described above. Variance of line widths was measured from 500 points in total, and a value of 3 Sigma, which was determined from the distribution of the measurements, was defined as LWR performance (nm). A smaller LWR performance value indicates being favorable with less unevenness of the lines. The LWR performance may be evaluated to be: "favorable" in the case of being no greater than 4.0 nm; or "unfavorable" in the case of being greater than 4.0.

**Table 3**

| | Radiation-sensitive composition | Development with alkali | |
|---|---|---|---|
| | | Eop (mJ) | LWR (nm) |
| Example 1 | J-1 | 32 | 3.5 |
| Example 2 | J-2 | 29 | 3.1 |
| Example 3 | J-3 | 33 | 3.5 |
| Example 4 | J-4 | 34 | 3.6 |
| Example 5 | J-5 | 35 | 3.7 |
| Example 6 | J-6 | 34 | 3.6 |
| Example 7 | J-7 | 32 | 3.4 |
| Example 8 | J-8 | 30 | 3.2 |
| Example 9 | J-9 | 30 | 3.2 |
| Example 10 | J-10 | 29 | 3.1 |
| Example 11 | J-11 | 28 | 3.1 |
| Example 12 | J-12 | 28 | 3.2 |
| Example 13 | J-13 | 25 | 2.9 |
| Example 14 | J-14 | 28 | 3.2 |
| Example 15 | J-15 | 30 | 3.3 |
| Comparative Example 1 | K-1 | 39 | 4.7 |
| Comparative Example 2 | K-2 | 38 | 4.8 |
| Comparative Example 3 | K-3 | 39 | 4.8 |
| Comparative Example 4 | K-4 | 39 | 4.8 |

As is clear from the results shown in Table 3, in forming the resist pattern through the exposure to EUV and the development with the alkali, the radiation-sensitive compositions of Examples exhibited more favorable sensitivity and LWR performance than the radiation-sensitive compositions of Comparative Examples. Accordingly, the radiation-sensitive composition of the embodiment of the present invention is concluded to be superior in the sensitivity and the LWR performance.

### [INDUSTRIAL APPLICABILITY]

The radiation-sensitive composition and the resist pattern-forming method according to the embodiments of the present invention enable a resist pattern with less LWR to be formed while achieving superior sensitivity. Therefore, these can be suitably used for working processes of semiconductor devices, and the like, in which microfabrication is expected to be further in progress hereafter.

## Claims

1. A radiation-sensitive composition comprising:
a polymer comprising a first structural unit that comprises an acid-labile group;
a first compound that generates a first acid upon an irradiation with a radioactive ray; and
a second compound that generates a second acid upon an irradiation with a radioactive ray,
wherein,
the first acid does not substantially dissociate the acid-labile group under a condition of a temperature of 110 °C and a time period of 1 min, and the second acid dissociates the acid-labile group under a condition of a temperature of 110 °C and a time period of 1 min, and
the radiation-sensitive composition satisfies at least one of requirements (1) and (2):
(1) the polymer comprises a monovalent iodine atom; and
(2) the radiation-sensitive composition further comprises a third compound that is other than the first compound or the second compound, and that comprises a monovalent iodine atom.

2. The radiation-sensitive composition according to claim 1, which satisfies the condition (2).

3. The radiation-sensitive composition according to claim 1 or 2, wherein the polymer further comprises a second structural unit that is other than the first structural unit and that comprises a monovalent iodine atom.

4. The radiation-sensitive composition according to any one of claims 1 to 3, wherein
the polymer further comprises a third structural unit that is other than the first structural unit, and that does not include a monovalent iodine atom but includes a monovalent fluorine atom-containing group represented by -CR^{A}R^{B}OR^{C}, a lactone structure, a cyclic carbonate structure, a sultone structure, a hydroxy group bonding to an aromatic ring, or a combination thereof, wherein: R^{A} represents a fluorine atom or a fluorinated alkyl group; R^{B} represents a hydrogen atom, a fluorine atom or a monovalent organic group having 1 to 20 carbon atoms; and R^{C} represents a hydrogen atom or a monovalent organic group having 1 to 20 carbon atoms.

5. The radiation-sensitive composition according to any one of claims 1 to 4, wherein a content of the second compound with respect to 100 parts by mass of the polymer is no less than 20 parts by mass.

6. A resist pattern-forming method comprising:
applying the radiation-sensitive composition according to any one of claims 1 to 5 directly or indirectly on a substrate;
exposing a film formed by the applying; and
developing the film exposed.

7. The resist pattern-forming method according to claim 6, wherein a radioactive ray used in the exposing is an extreme ultraviolet ray or an electron beam.

## Patentansprüche

1. Strahlungsempfindliche Zusammensetzung, die umfasst:
ein Polymer, das eine erste Struktureinheit umfasst, die eine säurelabile Gruppe umfasst;
eine erste Verbindung, die bei Bestrahlung mit einer Aktivstrahlung eine erste Säure erzeugt; und
eine zweite Verbindung, die bei Bestrahlung mit einer Aktivstrahlung eine zweite Säure erzeugt,
wobei,
die erste Säure die säurelabilen Gruppen unter der Bedingung einer Temperatur von 110°C und einer Zeitspanne von 1 min nicht wesentlich dissoziiert und die zweite Säure die säurelabilen Gruppen unter der Bedingung einer Temperatur von 110°C und einer Zeitspanne von 1 min dissoziiert, und
die strahlungsempfindliche Zusammensetzung zumindest eine der Bedingungen (1) und (2) erfüllt:
(1) das Polymer umfasst ein monovalentes Iodatom; und
(2) die strahlungsempfindliche Zusammensetzung umfasst ferner eine dritte Verbindung, die sich von der ersten Verbindung oder der zweiten Verbindung unterscheidet und die ein einwertiges Iodatom umfasst.

2. Die strahlungsempfindliche Zusammensetzung nach Anspruch 1, die die Bedingung (2) erfüllt.

3. Strahlungsempfindliche Zusammensetzung nach Anspruch 1 oder 2, wobei das Polymer ferner eine zweite Struktureinheit umfasst, die sich von der ersten Struktureinheit unterscheidet und die ein einwertiges Iodatom umfasst.

4. Die strahlungsempfindliche Zusammensetzung nach einem der Ansprüche 1 bis 3, wobei
das Polymer ferner eine dritte Struktureinheit umfasst, die sich von der ersten Struktureinheit unterscheidet und die kein einwertiges Iodatom enthält, sondern eine einwertige, ein Fluoratom enthaltende Gruppe, die durch -CR^{A}R^{B}OR^{C} dargestellt wird, eine Lactonstruktur, eine cyclische Carbonatstruktur, eine Sultonstruktur, eine Hydroxygruppe, die an einen aromatischen Ring gebunden ist, oder eine Kombination davon enthält, wobei R^{A} ein Fluoratom oder eine fluorierte Alkylgruppe darstellt; R^{B} ein Wasserstoffatom, ein Fluoratom oder eine monovalente organische Gruppe mit 1 bis 20 Kohlenstoffatomen darstellt; und R^{C} ein Wasserstoffatom oder eine monovalente organische Gruppe mit 1 bis 20 Kohlenstoffatomen darstellt.

5. Strahlungsempfindliche Zusammensetzung nach einem der Ansprüche 1 bis 4, wobei der Gehalt an der zweiten Verbindung, bezogen auf 100 Massenteile des Polymers, nicht weniger als 20 Massenteile beträgt.

6. Verfahren zur Bildung eines Resistmusters, das umfasst:
Aufbringen der strahlungsempfindlichen Zusammensetzung nach einem der Ansprüche 1 bis 5 direkt oder indirekt auf ein Substrat;
Belichten eines durch das Auftragen gebildeten Films; und
Entwickeln des belichteten Films.

7. Verfahren zur Bildung eines Resistmusters nach Anspruch 6, wobei die bei der Belichtung verwendete Aktivstrahlung eine extrem ultraviolette Strahlung oder ein Elektronenstrahl ist.

## Revendications

1. Composition sensible aux radiations comprenant :
un polymère comprenant un premier motif structurel qui comprend un groupe labile aux acides ;
un premier composé qui génère un premier acide suite à une irradiation par un rayonnement radioactif ; et
un deuxième composé qui génère un deuxième acide suite à une irradiation par un rayonnement radioactif,
dans laquelle
le premier acide ne dissocie pratiquement pas le groupe labile aux acides dans des conditions de température de 110 °C et de période de temps de 1 minute, et le deuxième acide dissocie le groupe labile aux acides dans des conditions de température de 110 °C et de période de temps de 1 minute, et
la composition sensible aux radiations satisfait à au moins l'une des exigences (1) et (2) :
(1) le polymère comprend un atome d'iode monovalent ; et
(2) la composition sensible aux radiations comprend en outre un troisième composé qui est autre que le premier composé ou le deuxième composé, et qui comprend un atome d'iode monovalent.

2. Composition sensible aux radiations selon la revendication 1, qui satisfait à la condition (2).

3. Composition sensible aux radiations selon la revendication 1 ou 2, dans laquelle le polymère comprend en outre un deuxième motif structurel qui est autre que le premier motif structurel et qui comprend un atome d'iode monovalent.

4. Composition sensible aux radiations selon l'une quelconque des revendications 1 à 3, dans laquelle
le polymère comprend en outre un troisième motif structurel qui est autre que le premier motif structurel, et qui ne contient pas d'atome d'iode monovalent mais qui contient un groupe contenant un atome de fluor monovalent représenté par -CR^{A}R^{B}OR^{C}, une structure de lactone, une structure de carbonate cyclique, une structure de sultone, un groupe hydroxy se liant à un cycle aromatique, ou une de leurs combinaisons, dans laquelle : R^{A} représente un atome de fluor ou un groupe fluoroalkyle ; R^{B} représente un atome d'hydrogène, un atome de fluor ou un groupe organique monovalent ayant 1 à 20 atomes de carbone ; et R^{C} représente un atome d'hydrogène ou un groupe organique monovalent ayant 1 à 20 atomes de carbone.

5. Composition sensible aux radiations selon l'une quelconque des revendications 1 à 4, dans laquelle la teneur en le deuxième composé pour 100 parties en masse du polymère n'est pas inférieure à 20 parties en masse.

6. Procédé de formation d'un motif de réserve comprenant :
l'application de la composition sensible aux radiations de l'une quelconque des revendications 1 à 5 directement ou indirectement sur un substrat ;
l'exposition d'un film formé par l'application ; et
le développement du film exposé.

7. Procédé de formation d'un motif de réserve selon la revendication 6, dans lequel un rayonnement radioactif utilisé dans l'exposition est un rayonnement ultraviolet extrême ou un faisceau d'électrons.
